(19)

**Europäisches Patentamt**
**European Patent Office**
**Office européen des brevets**

(11) **EP 2 711 746 A1**

(12) **EUROPEAN PATENT APPLICATION**
published in accordance with Art. 153(4) EPC

(43) Date of publication:
**26.03.2014 Bulletin 2014/13**

(21) Application number: **12785149.1**

(22) Date of filing: **17.05.2012**

(51) Int Cl.:
**G02B 5/18** (2006.01)     **G01J 3/18** (2006.01)
**G03F 1/00** (2012.01)     **G03F 7/20** (2006.01)
**H01L 21/027** (2006.01)

(86) International application number:
**PCT/JP2012/062622**

(87) International publication number:
**WO 2012/157697 (22.11.2012 Gazette 2012/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.05.2011 JP 2011111987**
**07.06.2011 JP 2011126877**

(71) Applicants:
• **Hitachi, Ltd.**
**Tokyo 100-8280 (JP)**
• **Hitachi High-Technologies Corporation**
**Tokyo 105-8717 (JP)**

(72) Inventors:
• **EBATA, Yoshisada**
**Hitachinaka-shi,**
**Ibaraki 312-8504 (JP)**

• **MATSUI, Shigeru**
**Hitachinaka-shi,**
**Ibaraki 312-8504 (JP)**
• **HASEGAWA, Norio**
**Minato-ku, Tokyo 105-8717 (JP)**
• **KAKUTA, Kazuyuki**
**Ome-shi, Tokyo 198-8512 (JP)**
• **ONOZUKA, Toshihiko**
**Ome-shi, Tokyo 198-8512 (JP)**

(74) Representative: **Calderbank, Thomas Roger**
**Mewburn Ellis LLP**
**33 Gutter Lane**
**London**
**EC2V 8AS (GB)**

(54) **DIFFRACTION GRATING MANUFACTURING METHOD, SPECTROPHOTOMETER, AND SEMICONDUCTOR DEVICE MANUFACTURING METHOD**

(57)     The present invention has been made in view of the above, and an object thereof is to provide a manufacturing technique capable of manufacturing a diffraction grating which is suitable for use in a spectrophotometer and has an apex angle of a convex portion of about 90° and can satisfy high diffraction efficiency and a low stray light amount. A method of manufacturing a diffraction grating, the method including: setting an exposure condition such that a sectional shape of a convex portion of a resist on a substrate, which has been formed by exposure, is an asymmetric triangle with respect to an opening portion shape of a mask having an opening portion with a periodic structure and an angle formed by a long side and a short side of the triangle is about 90°; and performing exposure.

FIG. 1

(REFERENCE)
CORRESPONDING
SECTIONAL SHAPE

**Description**

## TECHNICAL FIELD OF THE INVENTION

[Technical Field of First Technique]

The present invention relates to a diffraction grating manufacturing method for dispersing incident light to respective wavelengths. In particular, the present invention relates to a manufacturing method of a reflection-type one-dimensional blazed diffraction grating suitable for use in a spectrophotometer, which can take out diffracted light with a particular order of diffraction efficiently.

[Technical Field of Second Technique]

The present invention relates to a diffraction grating manufacturing method, and in particular to a technique suitably applied to a manufacturing method of a brazed diffraction grating having a blazed-shaped (saw-tooth wave-shaped) sectional configuration. The present invention relates to a technique suitably applied to a semiconductor device manufacturing method including an asymmetric shape.

## BACKGROUND OF THE INVENTION

[Background Art of First technique]

As described on pages 435 to 442 in Non-Patent Literature 1, a wavelength-dispersive spectrophotometer measures the transmittance or the reflectance of the sample by dispersing light emitted from a light source and taking out only a light component having a desired wavelength to irradiate a sample with the light component or by taking out only a light component having a desired wavelength after guiding light emitted from a light source to a sample. In the wavelength-dispersive spectrophotometer, diffraction gratings with grooves arranged periodically in one-dimensional direction are widely used.

In the spectrophotometer, since it is required to utilize energy of the light source effectively to perform measurement at a high S/N ratio, a reflection-type blazed diffraction grating which can take out only diffracted light with a particular order of diffraction efficiently is preferred in use as the kind of the diffraction grating.

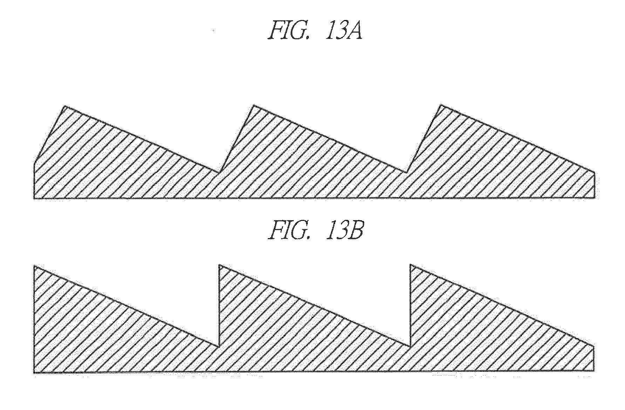

Further, since the spectrophotometer is generally frequently used over a wide wavelength range, it is desired to obtain significant diffraction efficiency in a wide incident angle range. Therefore, a sectional shape of grooves of the reflection-type blazed diffraction grating suitable for the spectrophotometer is not a saw-tooth shape, as shown in FIG. 13B, but it is an asymmetric triangular waveform having a convex portion with an apex angle of about 90°.

In the blazed diffraction grating, an inclined long side mainly contributes to reflection of diffracted light, but when incident light is vertically incident on the long side, the diffraction efficiency reaches the maximum, and a relationship of

$$\sin \alpha = \lambda/(2d \cdot \cos \rho) \qquad \cdots \text{ Equation 1}$$

exists between an inclined angle $\alpha$ of the long side and a wavelength $\lambda$ which can maximize the diffraction efficiency. Here, the angle p is 1/2 of an angle formed by an entrance slit center, a diffraction grating and an exit slit center in the spectrophotometer.

In a diffraction grating shown in FIG. 13B, a short side is required to be kept vertical to a surface of the diffraction grating regardless of an inclined angle of the long side, but in the diffraction grating shown in FIG. 13A, when the inclined angle of the long side is changed in response to a wavelength, diffraction efficiency of which should be maximized according to the Equation 1, it is also needed to change an inclined angle of the short side to the surface of the diffraction grating.

As described on pages 364 to 382 in Non-Patent Literature 1, the diffraction grating for a spectrophotometer is conventionally manufactured by a machine ruling system mainly using a ruling engine or a holographic exposure system based upon a two-beam interference using laser.

The groove shape shown in FIG. 13A can be produced by the ruling engine using a diamond blade edge having an apex angle of about 90° in a tool. On the other hand, in the holographic exposure system, only a diffraction grating having a groove having a sectional shape of Sin waveform (sine waveform, sinusoidal waveform) or a shape close to that could be manufactured. In recent years, however, for example, as described in Patent Literature 1, a technique of forming a periodic pattern on a photoresist film by holographic exposure, performing oblique ion beam etching using the photoresist film as a mask, thereby manufacturing a blazed diffraction grating is also disclosed. Further, recently, advance in technique is significant in a semiconductor manufacturing field, and as described in Patent Literature 2 or 3, a technique of manufacturing a blazed diffraction grating using the photolithography technique is disclosed.

[Background Art of Second Technique]

As the method of manufacturing a diffraction grating, for example, there are (1) a forming technique of a diffraction grating using a ruling engine and (2) a forming technique of a diffraction grating using the holographic exposure.

(1) The forming technique of a diffraction grating using a ruling engine is a technique of forming a blazed diffraction grating by machining utilizing the ruling engine using a diamond tool.
(2) The forming technique of a diffraction grating using the holographic exposure is a technique of forming a blazed diffraction grating by performing oblique etching to a resist pattern which has been subjected to holographic exposure. For example, as a technique regarding the holographic exposure, there are techniques described in Japanese Patent Application Laid-Open Publication No. 2005-11478 (Patent Literature 4), Japanese Patent Application Laid-Open Publication No. 2006-259325 (Patent Literature 5), and the like.

**Prior Art Literature**

**Patent Literature**

Patent Literature 1: Japanese Patent Application Laid-Open Publication No. H11-305023
Patent Literature 2: Japanese Patent Application Laid-Open Publication No. 2007-155927
Patent Literature 3: Japanese Patent Application Laid-Open Publication No. 2002-189112
Patent Literature 4: Japanese Patent Application Laid-Open Publication No. 2005-11478
Patent Literature 5: Japanese Patent Application Laid-Open Publication No. 2006-259325

**Non-Patent Literature**

Non-Patent Literature 1: Keiei KUDO, July, 1985, "BASE AND METHOD of SPECTRUM", Ohmsha Ltd.

## DISCLOSURE OF THE INVENTION

[Problem to be Solved by the Invention of First Technique]

When the transmittance or the reflectance of a sample in a desired wavelength is measured by the wavelength-dispersive spectrophotometer, an efficiency of taking out a light component having the desired wavelength depends on the diffraction efficiency of the diffraction grating. On the other hand, mixing of a light component having a wavelength other than the desired wavelength into the light component having the desired wavelength during the measurement must be avoided since it causes error in measurement of the transmittance or the reflectance. Such a light component is called "stray light".
In the diffraction grating used in the spectrophotometer, it is needless to say that it is required to ensure high diffraction efficiency and a low stray light amount. It is known that the diffraction efficiency of the blazed diffraction grating is determined according to the inclined angle and the flatness of a reflection surface, corresponding to the long side in the above-described sectional view and mainly contributing to diffracted light, of two reflection surfaces forming an asymmetric triangular-waveform section in FIG. 13A, and the squareness of the angle formed by the two faces. As the causes of the stray light, the disturbance of a groove period, roughness of the reflection surface corresponding to the long side, non-uniformity of a shape near an apex formed by intersection of two faces forming the saw-tooth waveform, and the like are known.
From these facts, in manufacture of a blazed diffraction grating, it is required to ensure the inclined angle, the squareness of the angle formed by two faces, the groove periods, and the uniformity of a shape near an apex formed by intersection of two faces with a high degree of accuracy to realize an excellent flatness and a low roughness on the reflection surface. In the manufacturing method using the conventional ruling engine, however, since the accuracy of a face to be machined is determined depending on a shape accuracy or a face accuracy of a tool to be used (generally, a tool having a diamond blade edge is used) itself, it is difficult to improve the accuracy up to a certain level or more.
As another request, there is such a request that periods of grooves should be set at unequal intervals for reduction of aberration generated at a spectroscopy time, a light condensing action or an imaging action simultaneously with a spectroscopy action, or the like. The holographic exposure system is advantageous for securing the flatness or the roughness of a face constituting grooves, or the like as compared with the ruling engine, but the holographic exposure system cannot satisfy the demand for forming grooves at optional unequal intervals.

As compared with these techniques, it can be easily anticipated that the technique of utilizing a recent semiconductor manufacturing technique which has been advanced as described above is advantageous for both forming grooves at optionally unequal intervals and improving face accuracy of a main reflection face. However, a sectional shape of grooves of a diffraction grating manufactured by the technique described in the above-described Patent Literature 2 or 3 is a saw-tooth shape such as that shown in FIG. 13B, and the Patent Literatures 2 and 3 describe a technique of making a rising angle of the short side vertical to the diffraction grating surface but they does not include a technique for making the short side orthogonal to the long side which is needed to be changed variously, and it is impossible to ensure the asymmetric triangular-waveform sectional shape as that shown in FIG. 13A.

The present invention has been made in view of the foregoing, and an object thereof is to provide a manufacturing technique capable of manufacturing a diffraction grating suitable for use in a spectrophotometer and capable of satisfying a high diffraction efficiency and a low stray light amount in a state where an apex angle of a convex portion is about 90°.

[Problem to be Solved by the Invention of Second Technique]

Now, regarding a forming technique of a diffraction grating such as described above, as the present inventor's result of study, the following matters have been clarified.

(1) Since the forming technique of a diffraction grating utilizing the ruling engine is machining, it has a limitation in accuracy improvement. Further, the forming technique is a dedicated technique for a diffraction grating and thus lacks expansivity. That is, the forming technique can only form parallel lines. In addition, the forming technique takes time for manufacturing a diffraction grating.

(2) Since the forming technique (including the above-described Patent Literatures 4 and 5) of a diffraction grating utilizing the holographic exposure requires an additional step, factors of variation in manufacture increase. That is, the diffraction grating only forms a sine curve, so that further exposure or machining is required in order to obtain an excellent diffraction grating. Further, a manufacturing apparatus for the additional step is required. Moreover, it is difficult to form non-periodic structure, unequal intervals or the like.

Therefore, the present invention has been made in view of the problems in (1) the forming technique of a diffraction grating utilizing the ruling engine and (2) the forming technique of a diffraction grating utilizing the holographic exposure, and a representative preferred aim thereof is to provide a manufacturing technique of a diffraction grating capable of achieving accuracy improvement of a product and reduction of a manufacturing time of the product.

025 The above and other preferred aims and novel characteristics of the present invention will be apparent from the description of the present specification and the accompanying drawings.

[Means for solving Problem of First Technique]

A manufacturing method solving the above problem is as follows:

A method of manufacturing a diffraction grating, including: setting an exposure condition such that, with respect to an opening portion shape of a mask having an opening portion with a periodic structure, a sectional shape of a convex portion of a resist on a substrate, the convex having been formed by exposure, is an asymmetric triangle and an angle formed by a long side and a short side of the triangle is about 90°; and performing exposure.

The typical ones of the inventions disclosed in the present application will be briefly described as follows.

That is, a summary of a typical invention is that method of manufacturing a diffraction grating having a blazed sectional shape, including: shaping light emitted from a light source to an illumination shape being asymmetric with respect to an optical axis and causing the light to pass through a mask provided with predetermined periodic patterns; causing zero-order light and first-order light generated by causing the light to pass through the mask to interfere with each other on a surface of the substrate and expose a photosensitive material on the surface of the substrate; and forming a diffraction grating having the blazed sectional shape on the substrate.

More preferably, when exposing a photosensitive material on a surface of the substrate, the method includes: causing light emitted from the light source to pass through the mask via the aperture, causing zero-order light and first-order light generated by causing the light to pass through the mask to interfere with each other on a surface of the substrate to expose the photosensitive material on a defocus side of a focal range where a constant imaging performance can be maintained, and forming a diffraction grating having the blazed sectional shape on the substrate.

**Effects of the Invention**

[Advantageous Effect of the Invention of First Technique]

According to the present invention, a diffraction grating with a convex portion having an apex angle of about 90° capable of satisfying a high diffraction efficiency and a low stray light amount can be manufactured. In particular, a diffraction grating with a convex portion having an apex angle of about 90° can be manufactured without performing etching to a pattern formed by exposure.

[Advantageous Effect of Invention of Second Technique]

That is, a typical effect can provide a manufacturing technique of a diffraction grating capable of achieving accuracy improvement of a product and reduction of a manufacturing time.

## BRIEF DESCRIPTIONS OF THE DRAWINGS

FIG. 1 is a diagram showing a structure of a gray-scale mask used in a method of manufacturing a diffraction grating according to a first example of the present invention [First Technique];
FIG. 2 is a diagram showing a section of a diffraction grating manufactured by the method of manufacturing a diffraction grating according to the first example of the present invention [First Technique];
FIG. 3 is a diagram showing a procedure of the method of manufacturing a diffraction grating according to the first example of the present invention [First Technique];
FIG. 4 is a diagram showing another procedure of the method of manufacturing a diffraction grating according to the first example of the present invention [First Technique];
FIG. 5 is a diagram showing an effect obtained when a focus value and an exposure amount are changed in the method of manufacturing a diffraction grating according to the first example of the present invention [First Technique];
FIG. 6 is a diagram showing an effect obtained when $\sigma$ value of illumination is changed in the method of manufacturing a diffraction grating according to the first example of the present invention [First Technique];
FIG. 7 is a diagram showing another structure of the gray-scale mask used in the method of manufacturing a diffraction grating according to the first example of the present invention [First Technique];
FIG. 8 is a diagram showing a structure of a binary mask used in a method of manufacturing a diffraction grating according to a second example of the present invention [First Technique];
FIG. 9 is a diagram showing a procedure of the method of manufacturing a diffraction grating according to the second example of the present invention [First Technique];
FIG. 10 is a diagram showing another procedure of the method of manufacturing a diffraction grating according to the second example of the present invention [First Technique];
FIG. 11 is a diagram showing an effect obtained when an overlap amount is changed in the method of manufacturing a diffraction grating according to the second example of the present invention [First Technique];
FIG. 12 is a diagram showing a configuration of a spectrophotometer using a diffraction grating manufactured by a method of manufacturing a diffraction grating according to a third example of the present invention [First Technique];
FIGS. 13A and 13B are diagrams for explaining kinds of a sectional shape of a blazed diffraction grating [First Technique] ;
FIGS. 14A to 14E are diagrams showing one example of an exposure apparatus realizing a method of manufacturing a diffraction grating of the first embodiment of the present invention [Second Technique] ;
FIG. 15 is a schematic diagram showing one example of an aperture used in the exposure apparatus shown in FIGS. 14A to 14E [Second Technique];
FIGS. 16A to 16C are schematic diagrams showing one example of a mask and a resist shape used in the exposure apparatus shown in FIGS. 14A to 14E [Second Technique];
FIGS. 17A to 17E are schematic diagrams showing a modified example of the aperture shown in FIG. 15 and the resist shape [Second Technique];
FIGS. 18A and 18B are schematic diagrams showing a first modified example of the mask and the resist shape shown in FIGS. 16A to 16C [Second Technique];
FIGS. 19A to 19E are schematic diagrams showing a second modified example of the mask and the resist shape shown in FIGS. 16A to 16C [Second Technique];

FIGS. 20A to 20D are schematic diagrams showing a third modified example of the mask and the resist shape shown in FIGS. 16A to 16C [Second Technique];

FIGS. 21A to 21C are schematic diagrams showing one example of apertures and resist shapes used in the exposure apparatus shown in FIGS. 14A to 14E of a second embodiment of the present invention [Second Technique] ;

FIGS. 22A and 22B are schematic diagrams showing one example of an exposure apparatus for achieving a method of manufacturing a diffraction grating of a third embodiment of the present invention and an aperture used in the exposure apparatus [Second Technique] ; and

FIGS. 23A and 23B are schematic diagrams showing one example of a mask and a resist shape used in the exposure apparatus shown in FIGS. 22A and 22B.

## DESCRIPTIONS OF THE PREFERRED EMBODIMENTS

[Embodiment for Carrying out Invention of First Technique]

Hereinafter, embodiment of the present invention will be described with reference to the drawings.

Example 1

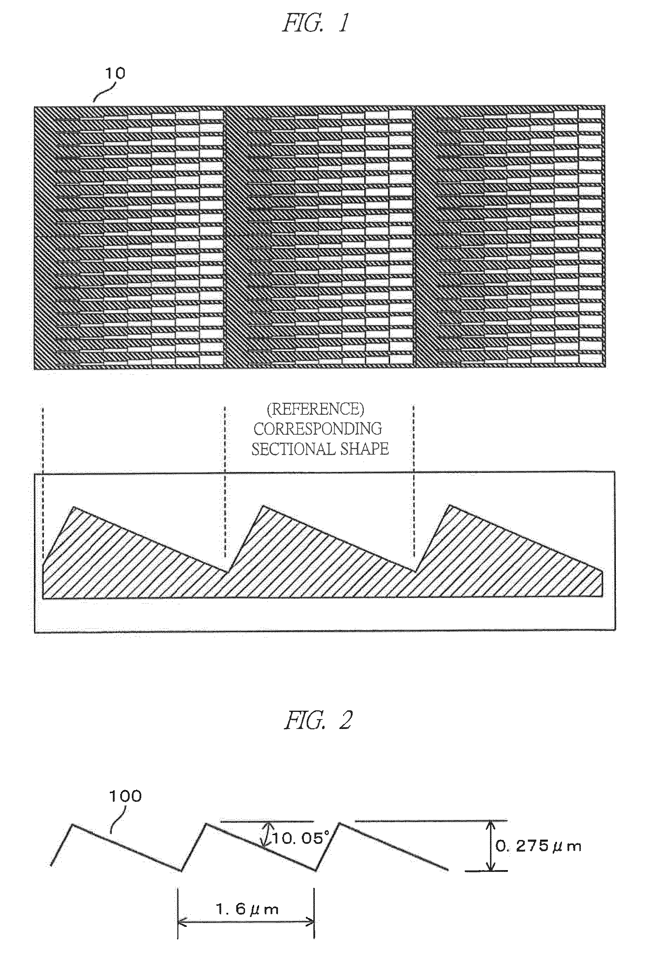

Here, as an example of a sectional shape of a diffraction grating to be manufactured, explanation will be made with reference to a diffraction grating 100 shown in FIG. 2.

The diffraction grating 100 shown in FIG. 2 is a reflection-type blazed diffraction grating with a groove period of 1.6 $\mu$m suitable for use in a spectrophotometer, which is configured such that when a monochromator of Czerny-Turner type mount where $\sigma$ in Equation 1 is 12° is used, the highest diffraction efficiency is obtained at a wavelength of 546 nm. Here, the inclined angle of the long side becomes about 10.05° and the depth of the groove becomes about 0.275 $\mu$m.

Incidentally, each of these numerical values is only one example, and the effect of the present invention is not limited to these numerical values or a combination(s) thereof.

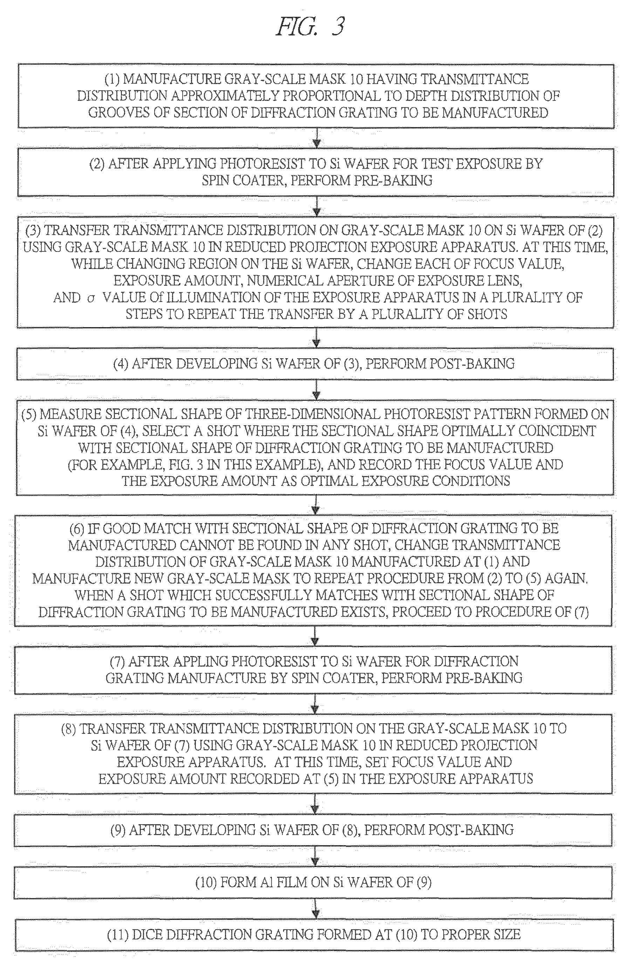

FIG. 3 shows a procedure of manufacturing the diffraction grating 100 on a Si wafer. Here, the term "gray-scale mask" indicates a photo mask configured so as to be capable of substantially changing the transmittance for each place on the photo mask such that exposure can be performed while the exposure amount is changed in a plural step fashion for each place within a shot region on a substrate of a Si wafer or the like simultaneously exposed by a reduction projection exposure apparatus.

Step 1: A gray-scale mask 10 having a transmission distribution substantially proportional to a depth distribution of a groove in a section of a diffraction grating to be manufactured is manufactured.

Step 2: After a photoresist is applied to a Si wafer for test exposure by a spin coater, the Si wafer is pre-baked.

Step 3 : The transmittance distribution on the gray-scale mask 10 is transferred to the Si wafer obtained at Step 2 by using the gray-scale mask 10 in a reduction projection exposure apparatus. Here, while a region is changed on the Si wafer, the transfer is repeated by a plurality of shots by changing each of the focus value, the exposure amount, the numerical aperture of an exposure lens, and the $\sigma$ value of illumination (the $\sigma$ value is a ratio of the numerical aperture of a light source to the numerical aperture of the projection lens) of the exposure apparatus in a plural step fashion.

Step 4: After the Si wafer at Step 3 is developed, it is post-baked.

Step 5: A sectional shape of a three-dimensional photoresist pattern formed on the Si wafer of Step 4 is measured. A shot where the sectional shape optimally coincides with a sectional shape (for example, FIG. 3 in this example) of a diffraction grating to be manufactured is selected and the focus value and the exposure amount thereof are recorded as an optimal exposure condition.

Step 6: If excellent match with a sectional shape of a diffraction grating to be manufactured cannot be found in any of the shots, the transmittance distribution of the gray-scale mask 10 manufactured at Step 1 is changed, a new gray-scale mask is manufactured, and the procedure from Step 2 to Step 5 is repeated again. When any shot where a sectional shape excellently matching with the sectional shape of a diffraction grating to be manufactured exists, the control proceeds to a procedure at Step 7.

Step 7: After a photoresist is applied on a Si wafer for diffraction grating manufacture by a spin coater, the Si wafer is pre-baked.

Step 8: The transmittance distribution on the gray mask 10 is transferred to the Si wafer obtained at Step 7 using the gray-scale mask 10 in a reduction projection exposure apparatus. At this time, the focus value and the exposure amount recorded at Step 5 are set in the exposure apparatus.

Step 9: After the Si wafer obtained at Step 8 is developed, it is post-baked.

Step 10: An Al film is formed on the Si wafer obtained at Step 9.

Step 11: A diffraction grating formed at Step 10 is diced to a proper size.

According to the above-described Steps, a diffraction grating with a convex portion having an apex angle of about 90° capable of achieving high diffraction efficiency and a low stray light amount can be manufactured. In particular, even if etching is not performed to a pattern which has been formed by exposure, a diffraction grating with a convex portion having an apex angle of about 90° can be manufactured.

The procedure from Step 1 to Step 6 shown in FIG. 3 shows a result obtained by actually manufacturing a gray-scale mask and using a Si wafer to perform exposure test, but instead, the optimal exposure condition of an exposure apparatus can also be determined by a computer simulation.

A computer simulation means (hereinafter, called "exposure simulator") can obtain, as numerical data, a solid geometry of a three-dimensional photoresist pattern which will be formed as the result obtained by performing the procedure from Step 1 to Step 4 in FIG. 3 according to computer simulation by inputting the transmittance distribution data of the gray-scale mask, the exposure characteristic of the reduction projection exposure apparatus, characteristics such as the sensitivity of the photoresist, and actual numerical values of other required parameters into the computer simulation means, and the optimal exposure conditions can be determined using this exposure simulator.

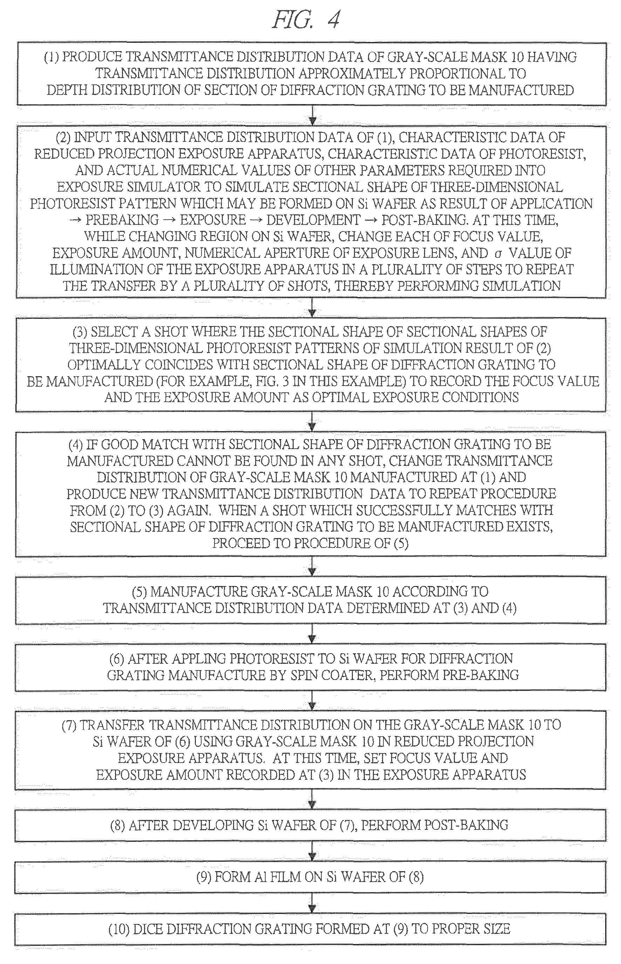

A diffraction grating manufacturing procedure when an exposure simulator is used is shown in FIG. 4. In this procedure, Step of manufacturing an actual gray-scale mask (Step 5 shown in FIG. 4) has been inserted before Step 7 shown in FIG. 3.

The structure of the gray-scale mask 10 used in the procedure shown in FIG. 3 or FIG. 4 is shown in FIG. 1.

The gray-scale mask 10 shown in FIG. 1 is a binary mask composed of one of an opening portion which allows exposure beam to pass through at an substantially-constant high transmittance and a light-shielding portion which almost blocks exposure beam and does not allow the exposure beam to pass through for each location, where lengths of a long side and a short side of a small opening represented by one rectangle in FIG. 1 are set equal to or less than a resolution limit of a reduction projection exposure apparatus used in the procedure. Therefore, in a light amount distribution of the light projected onto the Si wafer through the reduction projection exposure apparatus, small openings in FIG. 1 are not resolved at all, and the gray-scale mask 10 functions as a gray-scale mask whose transmittance virtually continuously changes in proportion to an aperture ratio of the small opening at the location for each location.

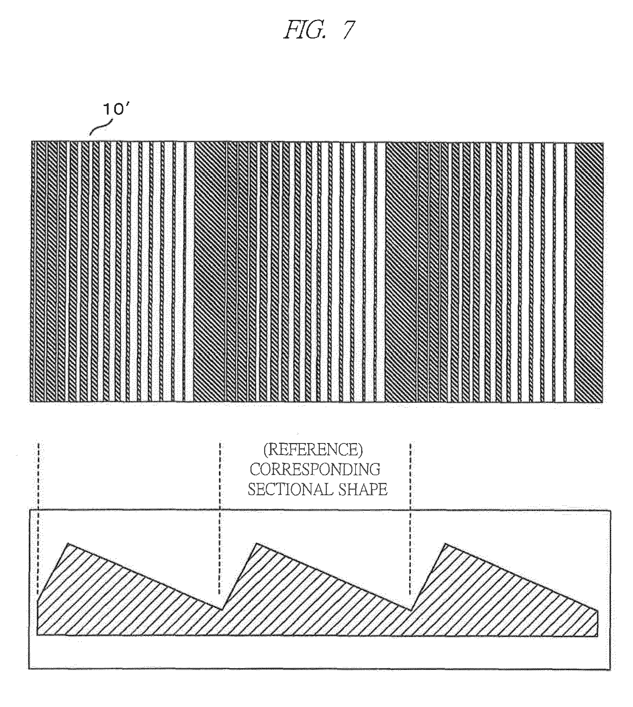

In FIG. 1, the small openings having the same width are arranged in a direction orthogonal to a longitudinal direction of a groove of the diffraction grating 100, but if the aperture ratio distributions for respective locations are set equal to one another, the small openings having the same width may be arranged in a direction parallel to the longitudinal direction of the groove of the diffraction grating 100, as shown in FIG. 7. Further, if the aperture ratio distributions for respective locations are set equal to one another, the shape of the small openings may be changed to the rectangles having different widths to circles having different diameters, or such an arrangement that a distribution density of circles having a constant diameter varies may be adopted.

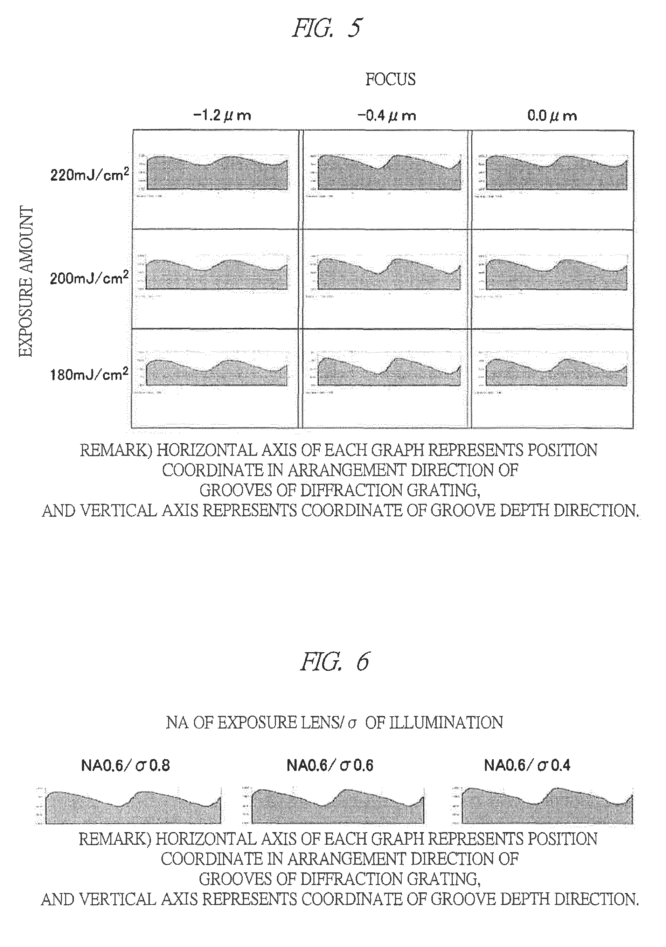

Examples of a sectional shape of a three-dimensional photoresist pattern formed when exposure is performed by using the gray-scale mask 10 shown in FIG. 1 and changing the exposure amount and the focus value at Step 2 in FIG. 3 are shown in FIG. 5. It is understood that a sectional shape obtained when a combination of the focus value of -0.4 $\mu$m and the exposure amount of 180 mJ/cm$^2$ is adopted is proximate to the sectional shape shown in FIG. 2.

Next, examples of a sectional shape of a three-dimensional photoresist pattern formed when, in addition to setting the focus value and the exposure amount to the above-described combination, the numerical aperture (NA) of the exposure lens is fixed to 0.6, and exposure is performed while the sigma ($\sigma$) value of illumination is changed are shown in FIG. 6. It is understood that the sectional shape obtained when the $\sigma$ value is 0.6 is approximate to the sectional shape shown in FIG. 2. In this case, the $\sigma$ value of illumination is determined as 0.6.

Also, at Step 6 in FIG. 3 or Step 4 in FIG. 4, when it is necessary to further modify the sectional shape of the gray-scale mask 10, a difference between the sectional shape of the formed three-dimensional photoresist pattern and the sectional shape of a diffraction grating to be manufactured may be added to sectional shape data of Step 1 in FIG. 3 or FIG. 4 as a correction term.

As a cause for occurrence of the difference between the sectional shape of the formed three-dimensional photoresist pattern and the sectional shape of a diffraction grating to be manufactured, there is generally lack in resolution of the reduction projection exposure apparatus or lack in number of gradations of change of the aperture ratio distribution in the gray-scale mask 10, so that the correction term is a spatial frequency component at a higher order than the cyclic period of the grooves in the diffraction grating. Therefore, instead of addition of the difference between the sectional shape of the formed three-dimensional photoresist pattern and the sectional shape of a diffraction grating to be manufactured as the correction term, a term obtained by multiplying the Sine waveform which is a harmonic of the cyclic period of the grooves in the diffraction grating by a proper coefficient may be added as the correction term in correction of the sectional shape of the gray-scale mask 10.

In the gray-scale mask 10 in FIG. 1, the case where intervals of grooves in the diffraction grating are constant is described, but since the periods of the grooves should be made unequal for reducing the aberration generated when the diffraction grating is used in the spectrophotometer, so as to cause the gray-scale mask to have a light condensing action or an imaging action simultaneously with a spectroscopy action, or the like, the transmittance distribution corresponding to the arrangement of the grooves may be set at unequal intervals on the gray-scale mask 10.

In this embodiment as configured as described above, since such a configuration as to control at least one of the focus, the exposure amount, the numerical aperture of the exposing lens, the σ value of illumination, and the transmittance distribution on the gray-scale mask of the reduction projection exposure apparatus is adopted in order to perform reduction projection exposure using the gray-scale mask and to cause the sectional shape of the three-dimensional photoresist pattern formed at the time of the reduction projection exposure to coincide with the sectional shape of a diffraction grating to be manufactured, a blazed diffraction grating which is suitably used in a spectrophotometer and has a sectional shape with a high precision where an apex angle of a convex portion is about 90° can be manufactured.

In this example, as the exposure wavelength of the reduction projection exposure apparatus, an ultraviolet part, for example, a wavelength such as 365nm, 248nm, 193nm or the like is used, but another wavelength may be used.

In this example, the photoresist is directly applied to the Si wafer, but when a standing wave in the photoresist film results in adverse effect, an antireflection film may be applied on the Si wafer before application of the photoresist.

In this embodiment, the Al film is directly formed on the three-dimensional photoresist pattern having been formed, but a dielectric film may be formed on the three-dimensional photoresist pattern as a protective coating before formation of the Al film.

In this example, the member obtained by forming the Al film on the three-dimensional photoresist pattern formed on the Si wafer is used as the diffraction grating as it is, but a member obtained by etching the Si wafer using the three-dimensional photoresist pattern as an etching mask and transferring the sectional shape of the three-dimensional photoresist pattern to the Si wafer itself may be used as the diffraction grating; or another substrate, such as, for example, a glass substrate which has been applied with resin for pattern transfer, to which a surface shape of the three-dimensional photoresist pattern is transferred by pressing (crimping) or the like may be used as the diffraction grating.

Further, as the photoresist, such a low-gamma photoresist that a difference in photoresist-remaining film between an exposed portion and an unexposed portion is substantially proportional to the exposure amount of the exposed portion may be used.

These modified example may be applied to Example 2.

**Example 2**

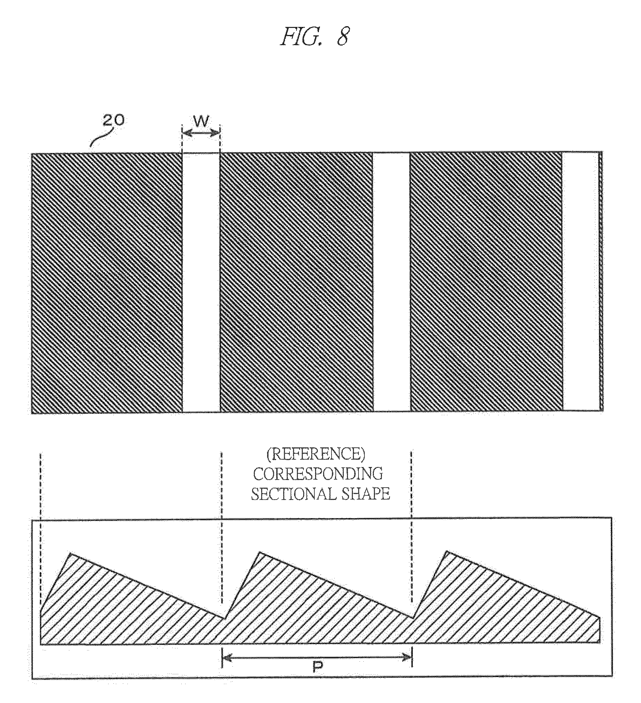

A second example of the present invention will be described with reference to each of FIG. 8 to FIG. 11.

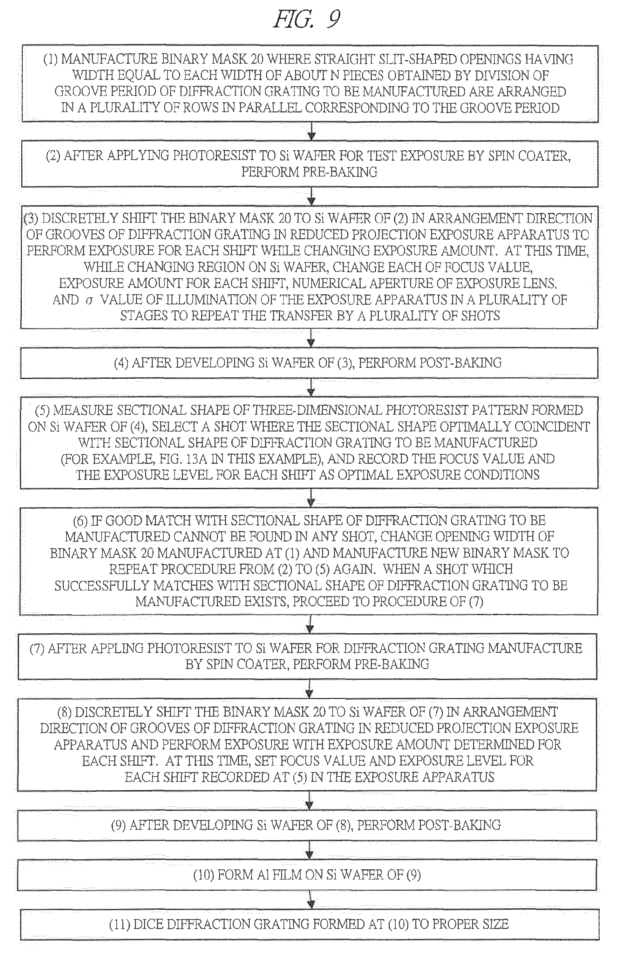

FIG. 9 shows a procedure for manufacturing a diffraction grating 100 on a Si wafer.

Step 1: A binary mask 20 in which a plurality of straight slit-shaped openings, which have a width equal to substantially one-Nth of the groove period obtained by dividing the groove period of a diffraction grating to be manufactured, are arranged in a plurality of rows in parallel corresponding to the groove periods is manufactured.

Step 2: After a photoresist is applied to a Si wafer for test exposure by a spin coater, the Si wafer is pre-baked.

Step 3: While the binary mask 20 is discretely shifted to the Si wafer of Step 2 in the arrangement direction of the grooves in the diffraction grating in a reduction projection exposure apparatus, exposure is performed while the exposure amount is changed for each shift. At this time, while a region is changed on the Si wafer, the transfer is repeated by a plurality of shots by changing each of the focus value, the exposure amount, the numerical aperture of an exposure lens, and the σ value of illumination of the exposure apparatus in a plural-step fashion.

Step 4: After the Si wafer of Step 3 is developed, it is post-baked.

Step 5: A sectional shape of a three-dimensional photoresist pattern formed on the Si wafer of Step 4 is measured. A shot in which the sectional shape is the best match with a sectional shape (for example, FIG. 13A) of a diffraction grating to be manufactured is selected, and the focus value and the exposure level for each shift are recorded as optimal exposure conditions.

Step 6: If excellent match with a sectional shape of a diffraction grating to be manufactured cannot be found in any of the shots, the opening width of the binary mask 20 manufactured at Step 1 is changed, a new binary mask is manufactured, and the procedure from Step 2 to Step 5 is repeated again. When any shot where a sectional shape excellently matches with the sectional shape of a diffraction grating to be manufactured exists, the control proceeds to a procedure at Step 7.

Step 7: After a photoresist is applied on a Si wafer for diffraction grating manufacture by a spin coater, the Si wafer is pre-baked.

Step 8: While the binary mask 20 is discretely shifted to the Si wafer of Step 7 in the arrangement direction of the grooves in the diffraction grating in the reduction projection exposure apparatus, exposure is performed with an exposure amount determined for each shift. At this time, the focus value and the exposure level for each shift which have been recorded at Step 5 are set in the exposure apparatus.

Step 9: After the Si wafer of Step 8 is developed, it is post-baked.

Step 10: An Al film is formed on the Si wafer of Step 9.

Step 11: A diffraction grating formed at Step 10 is diced to a proper size.

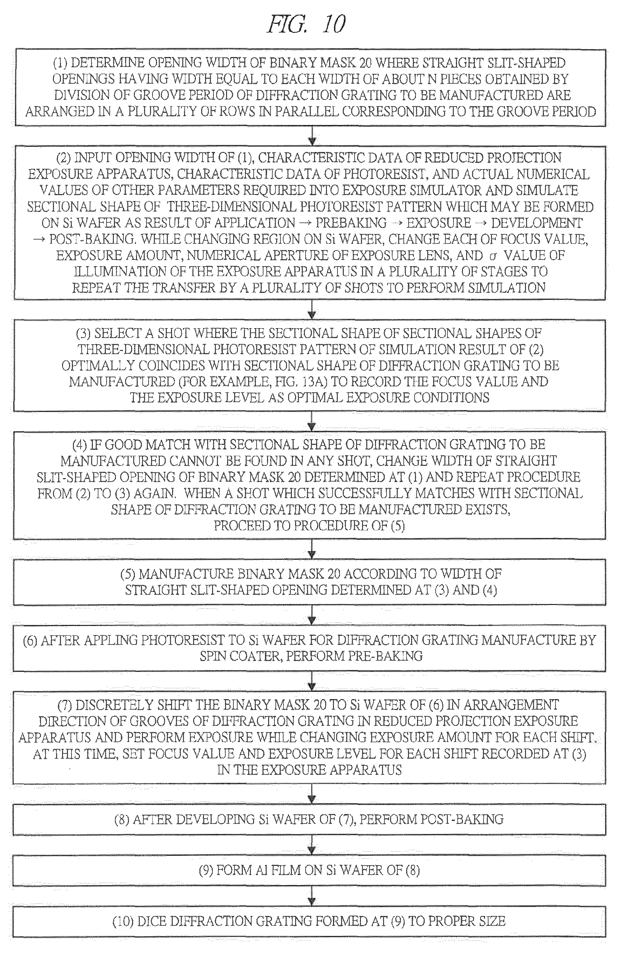

Regarding the procedure from Step 1 to Step 6 in FIG. 9, when the optimal exposure condition is determined using the exposure simulator like the first example, the diffraction grating manufacturing procedure is as that shown in FIG. 10.

The structure of the binary mask 20 used in the procedure shown in FIG. 9 or FIG. 10 is shown in FIG. 8. The binary mask shown in FIG. 8 is composed of periodic repetition of straight slit-shaped opening portions allowing pass of exposure beam with an substantially high transmittance and shielding portions existing between the opening portions and almost blocking exposure beam to prevent passing through thereof. The cyclic period corresponds to a groove period P of a diffraction grating to be manufactured.

The width W of the opening in a short side direction (however, showing a size of the opening projected on the Si wafer) is set to a width equal to each width of about N pieces obtained by division of the groove period of the diffraction grating to be manufactured (W > P/N), where a numerical value of N = about 4 to 8 is adopted as N. The larger N, the smoother the flatness of the reflection face of a three-dimensional photoresist pattern to be formed becomes, as described later; but the number of repetitions of exposure increases and a time required for exposure increases correspondingly, so that the magnitude (the value) of N should be determined based upon the tradeoff between the flatness and the time.

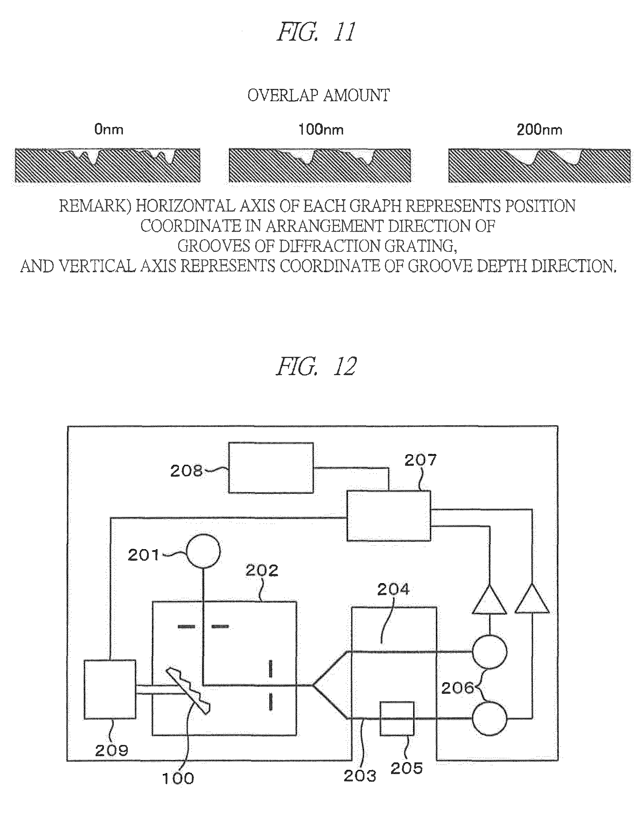

While the binary mask having the opening portions having the width W is shifted by a pitch S in a direction orthogonal to the groove direction of the diffraction grating to be manufactured, exposure is performed N times. Setting is performed such that S < W and a relationship of S x N = P are satisfied. At this time, in exposure in each stage, overlap with the previous exposure region by W - S occurs, but even if S is constant, an overlap amount can be changed by changing W. When the overlap amount is changed, the sectional shape of a three-dimensional photoresist pattern formed by exposure is changed like FIG. 11, for example. In the example shown in FIG. 11, it is understood that the sectional shape becomes proximate to the sectional shape shown in FIG. 2 in the case of the overlap amount = 200 nm. Thus, the optimal overlap amount is determined. In addition, the course of changing the focus, the exposure amount, the numerical aperture of the exposure lens, and the σ value of illumination of the reduction projection exposure apparatus such that the sectional shape of the three-dimensional photoresist pattern to be formed becomes proximate to the sectional shape of the diffraction grating to be manufactured, and the configuration required therefor are similar to those in the first Example.

**Example 3**

A third example of the present invention will be described with reference to FIG. 12. FIG. 12 shows the configuration of a spectrophotometer equipped with the diffraction grating 100 manufactured by the method of manufacturing a diffraction grating shown in the aspect of the example 1 or the aspect of the example 2.

White light emitted from a light source 201 is incident on a monochromator 202. The monochromator 202 houses the diffraction grating 100 driven by a wavelength driving system 209 therein, and a monochromic light with a desired measurement wavelength is taken out according to a command from a CPU 207. After the monochromic light is divided into a sample side beam 203 and a reference side beam 204, the sample side beam 203 passes through a sample 205 to be affected by spectral absorption characteristic of the sample. Here, when the concentration of the sample is high, the sample side beam is strongly subjected to absorption, so that the simple side beam 203 after passing through the sample 205 develops weak intensity. At this time, if the diffraction efficiency of the diffraction grating 100 is low, the light amount of the light source 201 cannot be utilized sufficiently, so that a high S/N cannot be obtained. Further, when a component other than a desired wavelength, which is not absorbed by the sample 205, so-called "stray light" is included in the sample beam, a measurement value includes an error corresponding to the intensity of the stray light.

After passing through the sample 205, the sample side beam 203 and the reference side beam 204 are incident on light detectors 206, respectively. Output signals of the light detectors 206 are taken in the CPU 207, where the absorbance of the sample 205 at the desired wavelength is computed from an intensity ratio of both the output signals and the absorbance is converted to the concentration of the sample 205. According to the method of manufacturing a diffraction grating shown in the first example or the second example of the present invention, since a diffraction grating having a high diffraction efficiency and reduced stray light can be manufactured, when a spectrophotometer equipped with the diffraction grating is configured, a light amount of weak light to be measured can be measured with an excellent S/N ratio and a concentration value of the sample can be measured accurately with excellent linearity even regarding a sample having a high concentration and a large light absorption amount.

[Embodiment for implementing the invention of the second technique]

The following embodiment will be described being divided into a plurality of embodiments or sections for convenience sake if necessary, but unless expressly stated otherwise, these embodiments or sections are not independent from one another, where one thereof is in a relationship with a modified example, details, a supplementary explanation, or the like of a portion or entirety of the other. However, these sections or embodiments are not irrelevant to each other unless otherwise stated, and the one relates to the entire or a part of the other as a modification example, details, or a supplementary explanation thereof. Also, in the embodiments described below, when referring to the number of elements (including number of pieces, values, amount, range, and the like), the number of the elements is not limited to a specific number unless otherwise stated or except the case where the number is apparently limited to a specific number in principle. The number larger or smaller than the specified number is also applicable.

Further, in the embodiments described below, it goes without saying that the components (including element steps) are not always indispensable unless otherwise stated or except the case where the components are apparently indispensable in principle. Similarly, in the embodiments described below, when the shape of the components, positional relation thereof, and the like are mentioned, the substantially approximate and similar shapes and the like are included therein unless otherwise stated or except the case where it is conceivable that they are apparently excluded in principle. The same goes for the numerical value and the range described above.

Hereinafter, embodiments of the present invention will be described in detail with reference to the accompanying drawings. Note that components having the same function are denoted by the same reference symbols throughout the drawings for describing the embodiment, and the repetitive description thereof will be omitted.

<Summary of Embodiments of the Present Invention>

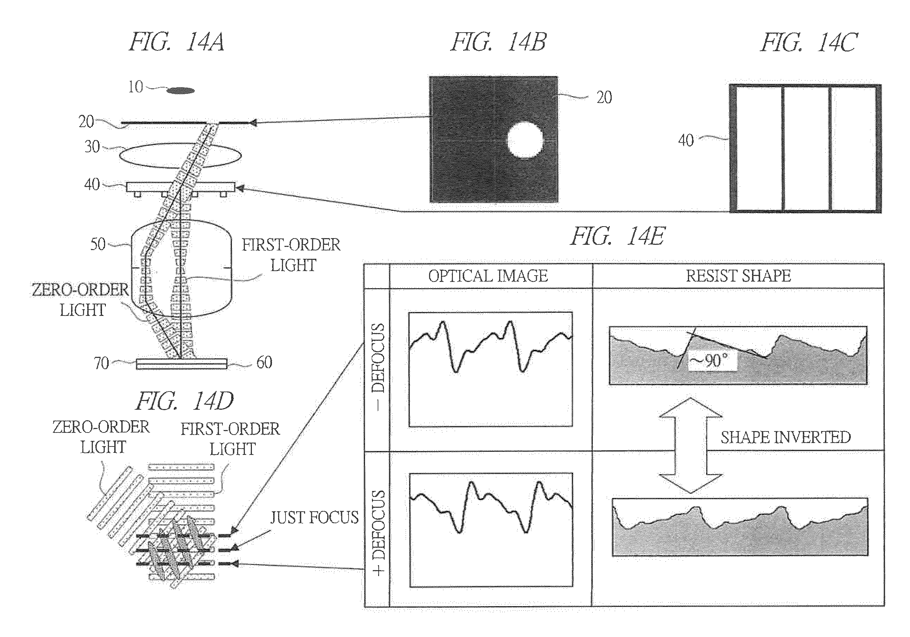

A method of manufacturing a diffraction grating which is an embodiment of the present invention is applied to a manufacturing method of a diffraction grating having a blazed sectional shape, a feature thereof is that light emitted from a light source (an illumination light source 10) is shaped to an illumination shape asymmetric with respect to an optical axis (using an aperture 20), it is caused to pass through a mask with a predetermined periodic pattern (mask 40), zero-order light and first-order light generated by causing the light to pass through the mask are caused to interfere with each other on a surface of a substrate (Si wafer 60) to expose a photosensitive material (photoresist 70) on the surface of the substrate so that a diffraction grating having a blazed sectional shape on the substrate is formed (as one example, components corresponding to FIG. 14 are quoted in parentheses).

Respective embodiments based upon the summary of the embodiment of the present invention which has been described above are specifically described below. The embodiments described below are examples using the present invention and the present invention is not limited by the following embodiments.

[First Embodiment]

A first embodiment of the present invention will be described with reference to FIG. 14A to FIG. 20D.

In a method of manufacturing a diffraction grating of the first embodiment, when an illumination shape asymmetric with respect to an optical axis is formed, an aperture having an opening portion being asymmetric with respect to the optical axis is used. Further, as the mask, a mask on which patterns are disposed corresponding to blazed pitches (equal intervals, unequal intervals) of a diffraction grating is used. When a photoresist on a surface of a Si wafer is exposed, light emitted from a light source is caused to pass through the mask via the aperture, zero-order light and first-order light generated by causing the light to pass through the mask are caused to interfere with each other on a surface of the Si wafer, and a photoresist is exposed on a defocus side (+ defocus side, - defocus side) of a focal range where a constant imaging performance can be maintained, a diffraction grating having a blazed sectional shape is formed on the Si wafer. In the following, the first embodiment will be described specifically with reference to FIG. 14A to FIG. 20D.

<Exposure Apparatus>

Referring to FIGS. 14A to 14E, an exposure apparatus realizing a method of manufacturing a diffraction grating according to the first embodiment will be described. FIGS. 14A to 14E are schematic diagrams showing one example of the exposure apparatus. FIG. 14A represents a schematic configuration of the exposure apparatus, FIG. 14B represents a shape of an aperture, FIG. 14C represents a shape of a mask, FIG. 14D represents details around DOF for exposing a photoresist on a Si wafer, and FIG. 14E represents optical images and resist shapes at positions of + defocus and - defocus.

As shown in FIG. 14A, the exposure apparatus according to the first embodiment is composed of an illumination light source 10, an aperture 20, a condensing lens 30, a mask 40, a projection lens 50, and the like. The exposure apparatus is an apparatus which utilizes a three-dimensional resist pattern forming technique using a deformed illumination method to expose a photoresist 70 applied to a surface of a Si wafer 60.

The illumination light source 10 is a light source for performing exposure. As the illumination light source 10, for example, g-line or i-line, an excimer laser of KrF, ArF, or the like, is used.

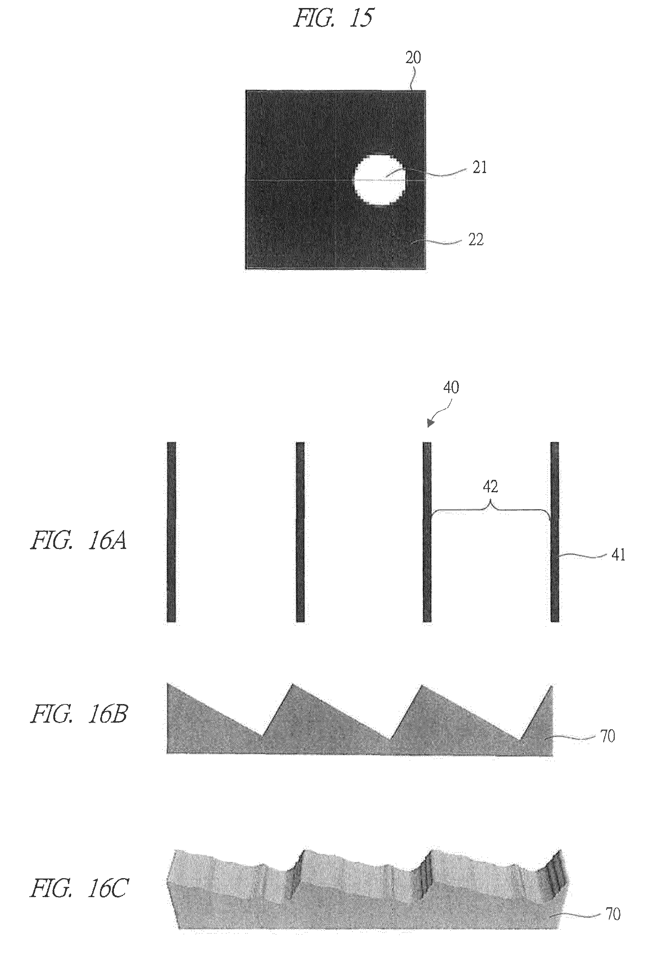

As shown in FIG. 14B (details are illustrated in FIG. 15), the aperture 20 is provided with an opening portion 21 being asymmetric with respect to an optical axis of the illumination light source 10, and it is for shaping light emitted from the illumination light source 10 to an illumination shape asymmetric with respect to the optical axis. In the aperture 20, the opening portion 21 is a portion allowing passing of light and the other portion thereof is a light-shielding portion 22 blocking light. In the example of the aperture 20 shown in FIG. 14B, a circular opening portion 21 (white representation) is provided on the right side of the optical axis (intersection between X axis and Y axis).

The condensing lens 30 is a lens for condensing light which has passed through the opening portion 21 of the aperture 20 on the mask 40.

As shown in FIG. 14C (details are illustrated in FIG. 16A), the mask 40 is provided with predetermined periodic patterns, and the patterns are disposed corresponding to blazed pitches of the mask 40. The patterns of the mask 40 are composed of repetition of lines 41 which are light-shielding portions for blocking light and spaces 42 which are transmissive portions allowing transmission of light. In the example shown in FIG. 14C, four lines 41 (black line representation) arranged at equal intervals are provided and spaces 42 (white line representation) are disposed among respective lines 41.

The projection lens 50 is a lens for projecting the repetitive pattern of the lines 41 and the spaces 42 on the mask 40 on a photoresist 70 of the Si wafer 60. Incidentally, in a method of manufacturing a diffraction grating described later, a reduction projection exposure apparatus which reduces a pattern of the mask 40 to project the same will be described.

In the exposure apparatus configured as described above, a deformed illumination method is used. The deformed illumination method is an illumination method that inserts an aperture provided with an opening portion 21 which is not positioned on an optical axis of an optical system to cause exposure beam to obliquely enter the mask 40. According to the deformed illumination method, the resolution and the DOF (depth of focus) can be improved by performing exposure using only zero-order light and first-order light diffracted by the mask 40. The DOF means a focal range where constant focusing perfarmance can be maintained.

In this embodiment, as shown in FIG. 14D, the photoresist 70 on the Si wafer 60 is exposed at a defocus position on the - (negative) side (a side near the illumination light source 10) (- defocus) and a defocus potion on the + (positive) side (a side far from the illumination light source 10) (+ defocus) relative to a just focus position of the DOF.

As a result of simulation of exposure of the photoresist 70 on the Si wafer 60 which has been performed at the + defocus position and the - defocus position, optical images (light intensity distributions) and resist shapes such as those shown in FIG. 14E have been obtained. That is, it has been found that the resist shapes can be formed to have a blazed sectional shapes and the shapes at the + defocus position and the - defocus position are inversed to each other. That is, at the - defocus position, such saw teeth are obtained that they have a steep inclination from each top of the saw teeth toward a V-shaped groove on the left side and a gentle inclination from each top of the saw teeth toward a V-shaped groove on the right side. On the other hand, at the + defocus position, such saw teeth are obtained that they have a gentle inclination from each top of the saw teeth toward a V-shaped groove on the left side and a steep inclination therefrom toward a V-shaped groove on the right side.

This embodiment has a feature such that, when the photoresist 70 on the surface of the Si wafer 60 is exposed by the exposure apparatus using the described-above deformed illumination method, light emitted from the illumination light source 10 is caused to pass through the mask 40 via the aperture 20, and the zero-order light and the first-order light generated by causing the light to pass through the mask 40 are caused to interfere with each other on the surface of the Si wafer 60 to expose the photoresist 70 at the + defocus position or the - defocus position of the DOF, so that a diffraction grating which has been formed with the photoresist 70 having the blazed sectional shape on the Si wafer 60 is formed. <Manufacturing Method of Diffraction Grating>

With reference to FIG. 15 and FIGS. 16A to 16C, a method of manufacturing a diffraction grating using the exposure apparatus shown in FIG. 14A will be described. FIG. 15 is a schematic diagram showing one example of an aperture used in the exposure apparatus. FIG. 16A to FIG. 16C are schematic diagrams showing one example of a mask and a resist shape used in the exposure apparatus. FIG. 16A shows a summary of the mask, FIG. 16B shows a sectional shape of a photoresist corresponding to the mask shown in FIG. 16A, and FIG. 16C shows a sectional shape of a photoresist corresponding to the mask shown in FIG. 16A according to simulation. The example of the sectional shapes of the photoresist shown in FIG. 16B and 16C corresponds to the case where exposure has been performed at the + defocus position. Incidentally, in the case where exposure has been performed at the - defocus position, the shapes are inverted.

(1) An aperture 20 provided with an opening portion 21 asymmetric with respect to an optical axis is prepared. In the aperture 20, the circular opening portion 21 (white representation) which allows passing through of light is provided on the right side of the optical axis, for example, as shown in FIG. 15.

(2) A mask 40 having line patterns arranged at pitches of a diffraction grating to be manufactured is prepared. In this mask 40, four lines 41 (black line representation) arranged at equal intervals and shielding light and spaces 42 provided among the respective lines 41 and allowing transmission of light are provided, for example, as shown in FIG. 16A.

(3) After a photoresist is applied to a Si wafer for test exposure by a spin coater, the Si wafer is pre-baked.

(4) Patterns are transferred on the Si wafer at the above-described (3) using the mask 40 in a reduction projection exposure apparatus. At this time, exposure is performed at the + defocus side or the - defocus side of the DOF, and while a region is changed on the Si wafer, the transfer is repeated by a plurality of shots by changing each of the focus value, the exposure amount, the numerical aperture of an exposure lens, of the exposure apparatus in a plural-step fashion.

(5) After the Si wafer at the above-described (4) is developed, it is post-baked if necessary.

(6) A sectional shape of a three-dimensional photoresist pattern formed on the Si wafer of the above (5) is measured. A shot where the sectional shape optimally matches with a sectional shape (for example, FIGS. 16B and 16C in this embodiment) of a diffraction grating to be manufactured is selected and the focus value and the exposure amount of the shot are recorded as optimal exposure conditions.

(7) If excellent match with a sectional shape of a diffraction grating to be manufactured cannot be found in any of the shots, the opening area, the opening position, and the opening shape of the aperture 20 at the above-described (1) are changed, a new aperture 20 is used, and the procedure from the above-described (3) to (6) is repeated again. When any shot where a sectional shape excellently matches with the sectional shape of a diffraction grating to be manufactured exists, the control proceeds to a procedure performed at the following (8) in order to manufacture a diffraction grating of a product.

(8) After a photoresist 70 is applied on a Si wafer 60 for diffraction grating manufacture by a spin coater, the Si wafer is pre-baked.

(9) The mask 40 is transferred to the Si wafer 60 of the above-described (8) using the aperture 20 provided with an opening portion 21 asymmetric with respect to an optical axis in a reduction projection exposure apparatus. At this time, exposure is performed at the + defocus side or the - defocus side of the DOF, and the focus value and the exposure amount of the optimal exposure condition recorded at the above-described (6) are set in the exposure apparatus.

(10) After the Si wafer 60 of the above-described (9) has been developed, it is subjected to post-baking, if necessary. At this time, a structure in which the photoresist 70 having an equally-spaced blazed sectional shape has been formed on the Si wafer 60, for example, such as that shown in FIG. 16C, can be obtained.

(11) An Al film is formed on the photoresist 70 on the Si wafer 60 of the above-described (10).

(12) A diffraction grating formed at the above-described (11) is diced to a proper size. Thereby, a product of a diffraction grating where an equally-spaced blazed photoresist 70 has been formed on the Si wafer 60, and the Al film has been further formed on the photoresists 70 is completed.

<Modified Example of Aperture>

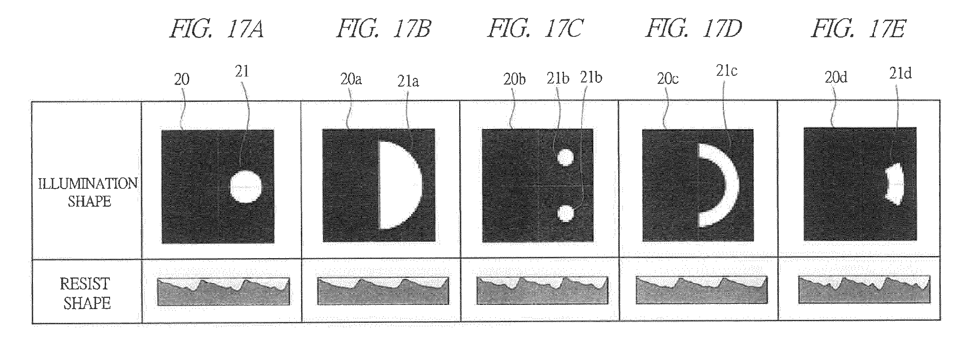

Referring to FIGS. 17A to 17E, the modified examples of the aperture shown in FIG. 15 will be described. FIG. 17A to 17E show sectional shapes of photoresists which have been obtained by simulation together with shapes of apertures, respectively. Further, for easy understanding of differences from the shapes of the modified examples, the example of the circular opening portion shown in FIG. 15 is illustrated in FIG. 17A.

In addition to the aperture 20 shown in FIG. 17A, diffraction gratings can be formed similarly by adopting apertures providing with an opening portion asymmetric with respect to an optical axis, such as shown in FIGS. 17B to 17E. FIG. 17B shows an example of an aperture 20a provided with a semi-circular opening portion 21a (white representation), FIG. 17C shows an example of an aperture 20b provided with two circular opening portions 21b (white representation), FIG. 17D shows an example of an aperture 20c provided with a semi-ring-shaped opening portion 21c (white representation), and FIG. 17E shows an example of an aperture 20d provided with a 1/6 ring-shaped opening portion 21d (white representation). Even in such modified examples, a diffraction grating in which an equally-spaced blazed photoresist 70 has been formed on the Si wafer 60 and the Al film has been formed on the photoresist 70 can be manufactured.

<First Modified Example of Mask>

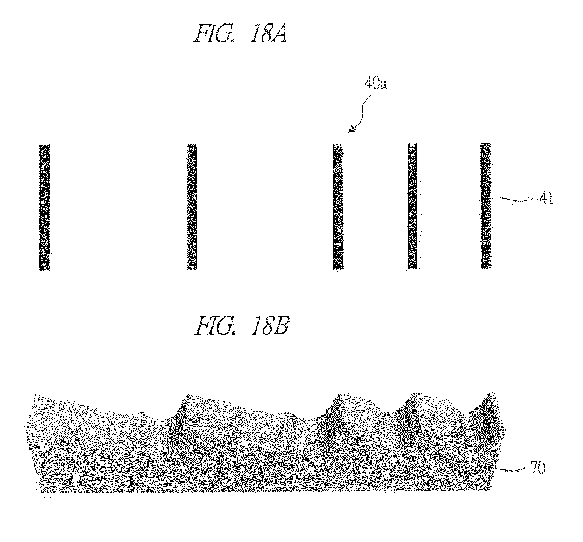

With reference to FIGS. 18A and 18B, a first modified example of the mask shown in FIG. 16A will be described. FIGS. 18A and 18B are schematic diagrams showing a mask and a first modified example having a resist shape. FIG.

18A shows a summary of the mask, and FIG. 18B shows a sectional shape of a photoresist corresponding to the mask shown FIG. 18A obtained by simulation.

In addition to the mask 40 having an equally-spaced layout pattern shown in FIG. 16A, a diffraction grating can be similarly formed to a mask 40a having an unequally-spaced layout pattern, such as that shown in FIG. 18A. In the example of the mask 40a shown in FIG. 18A, five lines 41 (black line representation) are provided at different pitches, respectively. In this modified example, as shown in FIG. 18B, a diffraction grating where a unequally-spaced blazed photoresist 70 has been formed on a Si wafer 60 and an Al film has been formed on the photoresist 70 can be manufactured.

As usages of such an unequally-spaced diffraction grating, for example, it can be used in (1) a situation that aberration of a concave diffraction grating is reduced and resolution is improved, (2) a situation that an imaging surface of a concave diffraction grating is a curved face, but the imaging face is made flat so that a diode array detector or a CCD (Charge Coupled Device) can be used, (3) a situation that an imaging performance is brought to a flat diffraction grating, and the like.

<Second Modified Example of Mask>

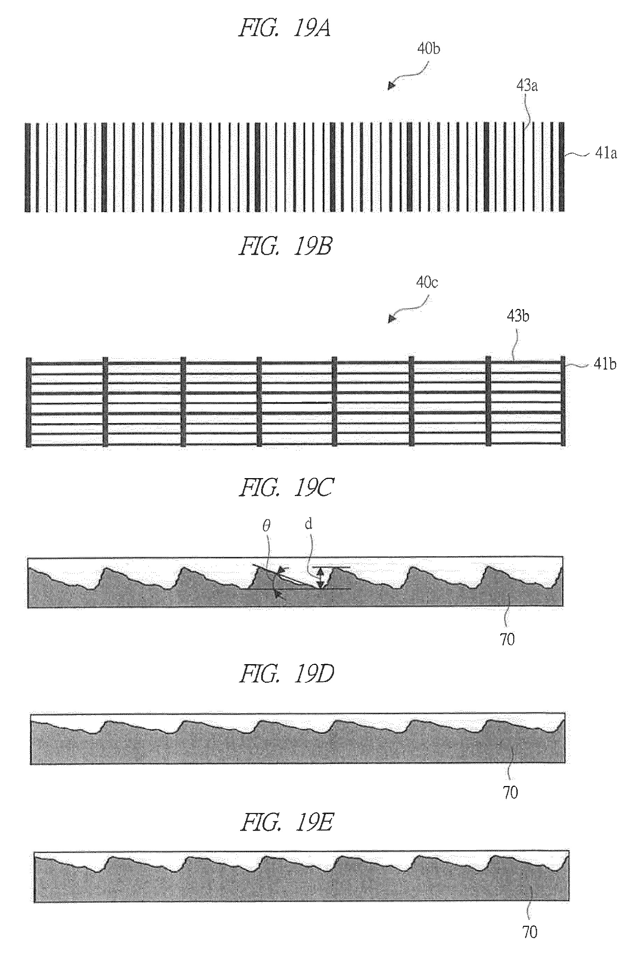

With reference to FIGS. 19A to 19E, a second modified example of the mask shown in FIG. 16A will be described. FIGS. 19A and 19E are schematic diagrams showing a mask and a second modified example having a resist shape. FIG. 19A shows a summary of a mask having auxiliary patterns (Y direction), FIG. 19B shows a summary of a mask having auxiliary patterns (X direction), FIG. 19C shows a sectional shape of a photoresist corresponding to a mask having no auxiliary patterns according to simulation, FIG. 19D shows a sectional shape of a photoresist corresponding to the mask of FIG. 19A having auxiliary patterns (Y direction) according to simulation, and FIG. 19E shows a sectional shape of a photoresist corresponding to the mask of FIG. 19B having auxiliary patterns (X direction).

The aperture 20 (20a to 20d) provided with an opening portion asymmetric with respect to an optical axis, such as that described above, is used, and a mask 40b having lines 43a (black line representation) of an auxiliary pattern arranged in the Y direction in addition to the lines 41a (black line representation) of the main pattern, as shown in FIG. 19A, or a mask 40c having lines 43b (black line representation) of the auxiliary pattern arranged in the X direction in addition to lines 41b (black line representation) of the main pattern, as shown in FIG. 19B, is used. In the mask 40b and the mask 40c, such as those described above, it is made possible to change angles (depths) of the blazed diffraction grating by adjusting the size of the auxiliary pattern (a line width of a line, the number of lines, or the like). The angle of the blazed diffraction grating is also called "blazed angle", and it is shown as $\theta$ in FIG. 19C. Further, the depth of the blazed diffraction grating is shown as d in FIG. 19C.

In the sectional shape of the photoresist 70 shown in FIG. 19D corresponding to the mask 40b with the auxiliary pattern (Y direction) shown in FIG. 19A, the blazed angle can be made smaller than that in the sectional shape of the photoresist 70 shown in FIG. 19C corresponding to the mask having no auxiliary pattern (corresponding to the mask 40 shown in FIG. 16A). In other words, the depth can be made shallow. Similarly, even in the sectional shape of the photoresist 70 shown in FIG. 19E corresponding to the mask 40c with the auxiliary pattern (X direction) shown in FIG. 19B, the blazed angle can be made small (the depth can be made shallow) .

Such a diffraction grating whose angles (depths) can be changed can be used, in a case that angles in one diffraction grating (the same pitch) are equal, a case that angles in one diffraction grating are different, or the like. Further, even when angles in one diffraction grating (the same pitch) are equal, there are such a diffraction grating in which each angle is large (the depth is deep), such as that shown in FIG. 19C, a diffraction grating in which each angle is small (the depth is shallow), such as that shown in FIGS. 19D and 19E, and the like. Further, the case that angles in one diffraction grating are different is used, for example, in a case that a diffraction grating is divided into four pieces such that each angle in a first piece are small (the depth is shallow), each angle in a second piece is large (the depth is deep), each angle in a third piece is small, and each angle in a fourth piece is large, and the diffraction efficiency is increased in a wide wavelength range.

<Third Modified Example of Mask>

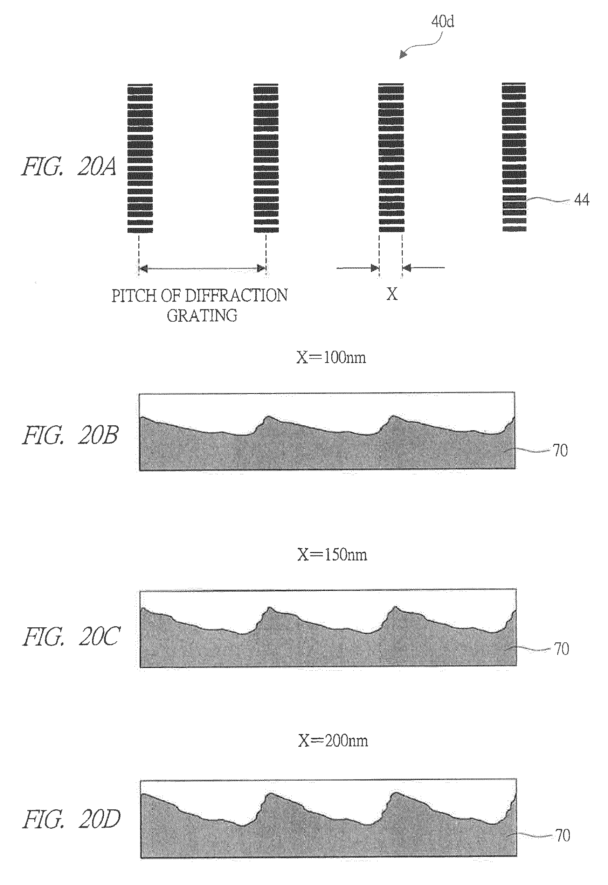

A third modified example of the mask shown in FIGS. 16A to 16C will be described with reference to FIGS. 20A to 20D. FIGS. 20A to 20D are schematic diagrams showing the third modified example of a mask and a resist shape. FIG. 20A shows summary of a line-and-space mask arranged to have a resolution equal to or less than a resolution limit, FIG. 20B shows a sectional shape of a photoresist corresponding to a mask in which a length of the lines and spaces in FIG. 20A is 100 nm according to simulation, FIG. 20C shows a sectional shape of a photoresist corresponding to a mask in which a length of the lines and spaces in FIG. 20A is 150 nm according to simulation, and FIG. 20D shows a sectional shape of a photoresist corresponding to a mask in which a length of the lines and spaces in FIG. 20A is 200 nm according to simulation.

The aperture 20 (20a to 20d) provided with an opening portion asymmetric with respect to an optical axis, such as that described above, is used, and a mask 40d where fine lines and spaces 44 (a line portion is represented by a black line) having pitches equal to or less than the resolution limit, shown in FIG. 20A are arranged at a pitch of a desired diffraction grating is used. In the mask 40d, it is made possible to change angles (depths) in the diffraction grating by changing the length X of the lines and spaces 44.

As shown in FIGS. 20B, 20C and 20D, the blazed angle can be made large (the depth can be made deeper) according to changes of the length X of the lines and spaces 44 to 100 nm → 150 nm → 200 nm. Such a diffraction grating where the angles (the depths) can be changed is used in an application similar to that of a diffraction grating such as that shown in FIGS. 19A to 19E.

<Advantageous Effect of First Embodiment>

According to the first embodiment described above, the following advantageous effects can be obtained by using the aperture 20 (20a to 20d) provided with an opening portion 21 (21a to 21d) being asymmetric with respect to an optical axis and using the mask 40 (40a to 40d) in which patterns are arranged corresponding to blazed pitches in the diffraction grating, causing light emitted from the illumination light source 10 to pass through the mask 40 (40a to 40d) via the aperture 20 (20a to 20d), causing zero-order light and first-order light, which are generated by causing the light to pass through the mask 40 (40a to 40d), to interfere with each other on the surface of the Si wafer 60 to expose the photoresist 70 on the surface of the Si wafer 60 on the + defocus side or the - defocus side of the DOF, and manufacturing a diffraction grating in which the photoresist 70 having the equally-spaced or unequally-spaced blazed sectional shape with equal angles (depths) or different angles (depths) has been formed on the Si wafer 60.

(1) As compared with the ruling engine, reduction in manufacturing time (for example, master manufacture: one month per one sheet → one day per one sheet) and accuracy improvement can be made possible, and formation of lines other than parallel lines can be made possible.
(2) As compared with the holographic exposure, since an additional step such as an oblique etching is not required, reduction in manufacturing time and accuracy improvement of a product can be made possible. Further, a diffraction grating and another diffraction grating having unequal spaces or blazed angles/depths changed from that of the former diffraction grating can be formed simultaneously.
(3) As an effect from the point of view of the entire product of the diffraction grating, the embodiment can contribute performance improvement of a diffraction grating such as diffraction efficiency improvement due to reduction in manufacturing variations or reduction in stray light.
(4) As an effect from the point of view of the entire product of the diffraction grating, the embodiment can provide a manufacturing technique of a diffraction grating which can achieve accuracy improvement and reduction in manufacturing time of a product.

The reasons why advantageous effects such as those of the above-described (1) to (4) are obtained are as follows:

(11) Since the photolithography technique is a manufacturing method with a high throughput for responding to mass production of semiconductor products, it is possible to reduce a manufacturing time.
(12) Since the photolithography technique is a technique of forming a pattern by utilizing a short-wavelength light source for responding to miniaturization and high precision of semiconductor products, it is possible to achieve high precision as compared with the ruling engine which performs ruling with a diamond tool having the same size as a diffraction grating to be manufactured.
(13) Since this embodiment makes it possible to cause an optical image to have inclination by one-time exposure, an additional step is not required. Therefore, it is made possible to reduce manufacturing variations and improve machining precision as compared with the holographic exposure requiring an additional step.
(14) Since the lithographic technique is a technique for transferring an arbitrary mask layout pattern on a photoresist applied to a Si wafer, unequally-spaced patterns can be formed. Further, since there is also an applied technology where a blazed angles can be changed by arranging auxiliary patterns, a diffraction grating and another diffraction grating having blazed angles/depths changed from that of the former diffraction grating can be formed simultaneously.

[Second Embodiment]

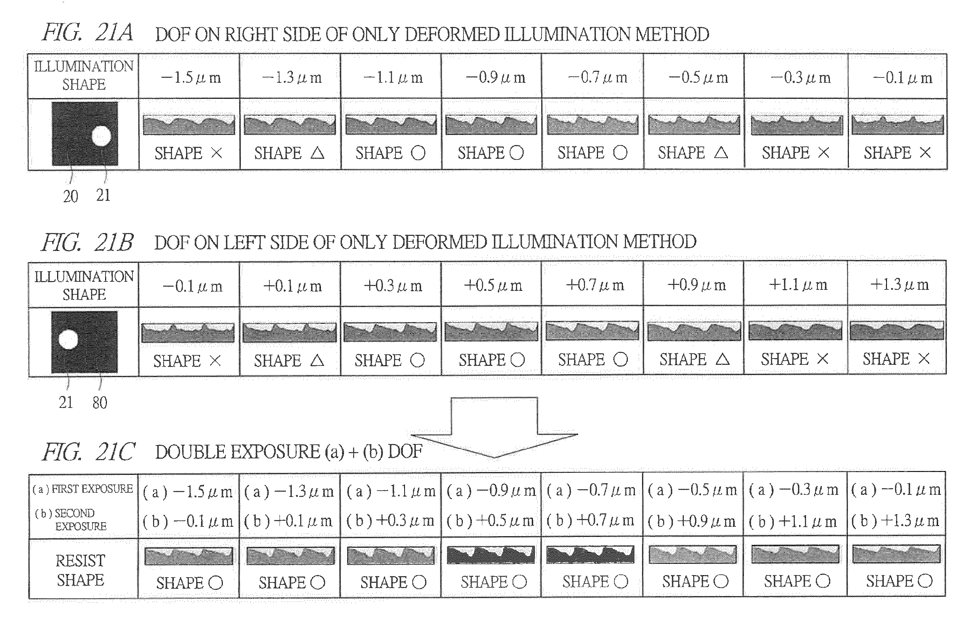

A second embodiment of the present invention will be described with reference to FIGS. 21A to 21C.

In a method of manufacturing a diffraction grating of the second embodiment, when an illumination shape being asymmetric with respect to an optical axis is formed, a first aperture provided with an opening portion being asymmetric with respect to the optical axis and a second aperture provided with an opening portion being asymmetric with respect to the first aperture and inverted therefrom are used. Further, as the mask, a mask in which patterns are arranged corresponding to brazed pitches (equal intervals, unequal intervals) of a diffraction grating is used. When a photoresist is exposed on a surface of a Si wafer, light emitted from a light source is caused to pass through the mask via the first aperture and the second aperture, zero-order light and first-order light generated by causing the light to pass through the mask are caused to interfere with each other on the surface of the Si wafer to expose the photoresist on defocus sides (a combination of + defocus sides, a combination of - defocus sides, or a combination of the + defocus side and the - defocus side) within a focal range in which a constant imaging performance can be maintained, thereby forming a diffraction grating with a blazed sectional shape on the Si wafer. In the following, portions different from the first embodiment will be mainly described specifically with reference to FIGS. 21A to 21C.

<Manufacturing Method of Diffraction Grating (Double Exposure) >

A method of manufacturing a diffraction grating using the exposure apparatus shown in FIG. 14A according to the second embodiment will be described with reference to FIGS. 21A to 21C. FIGS. 21A to 21C are schematic diagrams showing one example of an aperture and a resist shape used in the exposure apparatus, FIG. 21A shows a sectional shape of a photoresist according to simulation when the DOF has been applied to only the deformed illumination method on the right side using the first aperture, FIG. 21B shows a sectional shape of a photoresist according to simulation when the DOF has been applied to only the deformed illumination method on the left side using the second aperture, and FIG. 21C shows a sectional shape of a photoresist according to simulation when a double exposure DOF of the deformed illumination method has been applied using the first aperture and the second aperture.

The aperture 20 shown in FIG. 21A is the same as the aperture shown in FIG. 15, and it has a circular opening portion 21 (white representation) allowing transmission of light provided on the right side of the optical axis. The result of simulation using the aperture 20 has shown that the sectional shape of the photoresist is x (bad) at the - defocus position of -1.5 $\mu$m, it is $\Delta$ (slightly good) at the - defocus position of -1.3 $\mu$m, it is O (good) at the- defocus positions of -1.1 $\mu$m, -0.9 $\mu$m, and 0.7$\mu$m, it is $\Delta$ at the - defocus position of -0.5 $\mu$m, and it is x at the - defocus positions of -0.3 $\mu$m and -0.1 $\mu$m.

On the other hand, an aperture 80 shown in FIG. 21B is provided with an opening portion 21 inverted regarding the aperture 20 shown in FIG. 21A, where a circular opening portion 21 allowing transmission of light (white representation) is provided on the left side of the optical axis. The result of simulation using the aperture 80 has shown that the sectional shape of a photoresist is x at the - defocus position of -0.1 $\mu$m, it is $\Delta$ at the + defocus position of +0.1 $\mu$m, it is O at the + defocus positions of +1.3 $\mu$m, +0.5 $\mu$m, and +0.7$\mu$m, it is $\Delta$ at the + defocus position of +0.9 $\mu$m, and it is x at the + defocus positions of +1.1 $\mu$m and +1.3 $\mu$m.

In view of these results, in the method of manufacturing a diffraction grating according to the present embodiment, as shown in FIG. 21C, the aperture 20 shown in FIG. 21A and the aperture 80 shown in FIG. 21B are used, the first exposure is performed using the aperture 20 shown in FIG. 21A, and the second exposure is performed using the aperture 80 shown in FIG. 21B. The result of simulation using the two apertures 20 and 80 has shown that the sectional shapes of the photoresist is O at the respective defocus positions of a combination of -1.5 $\mu$m and -0.1 $\mu$m, a combination of -1.3 $\mu$m and +0.1 $\mu$m, a combination of -1.1 $\mu$m and +0.3 $\mu$m, a combination of -0.9 $\mu$m and +0.5 $\mu$m, a combination of -0.7 $\mu$m and +0.7 $\mu$m, a combination of -0. 5 $\mu$m and +0. 9 $\mu$m, a combination of -0.3 $\mu$m and +1.1 $\mu$m, and a combination of -0.1 $\mu$m and +1.3 $\mu$m.

By performing double exposure using a combination of - defocus positions or a combination of - defocus position and + defocus position, as shown in FIG. 21C, or a combination of + defocus positions which is not shown in this example, a diffraction grating with improved focus margin can be formed. In the following, the method of manufacturing a diffraction grating (double exposure) will be described.

(1) Two apertures having illumination shapes asymmetric with respect to an optical axis and mirror-inversed are prepared. That is, an aperture 20 having an opening portion 21 provided on the right side of the optical axis as shown in FIG. 21A, and an aperture 80 having an opening portion 21 provided on the left side of the optical axis as shown in FIG. 21B, are prepared.

(2) A mask 40 where line patterns have been arranged at pitches of a diffraction grating to be manufactured (for example, the mask shown in FIG. 16A in the first embodiment) is prepared.

(3) After a photoresist has been applied to two Si wafers for test exposure by a spin coater, pre-baking is performed.

(4) A pattern is transferred to one of the Si wafers obtained at the above-described (3) using the aperture 20 and the mask 40 in a reduction projection exposure apparatus. Here, exposure is performed on the + defocus side and/or the - defocus side of the DOF, and while a region is changed on the Si wafer, the transfer is repeated by plural shots by changing each of the focus value, the exposure amount, the numerical aperture of an exposure lens of the exposure apparatus in a plural-step fashion. Next, similar exposure is performed to the other Si wafer obtained at the above (3) using the aperture 80 and the mask 40.

(5) After the two Si wafers obtained at the above (4) have been developed, post-baking is performed, if necessary.

(6) The sectional shapes of the three-dimensional photoresist patterns formed on the Si wafers obtained at the above (5) are measured, and a shot where the sectional shape optimally coincides with a sectional shape of a diffraction grating to be manufactured is selected and the focus value and the exposure level of the shot are recorded as optimal exposure conditions.

(7) If excellent match with the sectional shape of the diffraction grating to be manufactured cannot be found in any of the shots, the opening areas, the opening positions, and the opening shapes of the apertures 20 and 80 obtained at the above (1) are changed, and the procedure from the above (3) to (6) is repeated using new apertures 20 and 80 again. When any shot where a sectional shape excellently coincides with the sectional shape of the diffraction grating to be manufactured exists, the control proceeds to a procedure of the following (8) in order to manufacture a diffraction grating of a product.

(8) After a photoresist is applied on a Si wafer for diffraction grating manufacture by a spin coater, pre-baking is applied to the Si wafer.

(9) The mask 40 is twice transferred to the Si wafer of the above-described (8) utilizing an illumination shape asymmetric with respect to an optical axis and using the apertures 20 and 80 whose shapes have been mirror-inverted by a reduction projection exposure apparatus. Here, exposure is performed on the + defocus side and/or the - defocus side of the DOF, and values of 1/2 of the focus value and the exposure amount of the optimal exposure condition recorded at the above-described (6) are set in the exposure apparatus.

(10) After the Si wafer of the above-described (9) is developed, it is post-baked, if necessary. Here, a structure where the photoresist having an equally-spaced blazed sectional shape has been formed on the Si wafer can be obtained.

(11) An Al film is formed on the photoresist on the Si wafer of the above-described (10).

(12) A diffraction grating formed at the above-described (11) is diced to a proper size. Thereby, a product of a diffraction grating where the blazed photoresist is formed on the Si wafer, and the Al film is further formed on the photoresist is completed.

<Modified Example of Aperture>

The aperture can be modified in the same manner as the first embodiment, where if there are each of the apertures 20a to 20d shown in FIGS. 17B to 17E and an aperture whose shape has been mirror-inverted regarding each of the apertures 20a to 20d, as apertures other than the apertures 20 and 80 shown in FIGS. 21A and 21B, a diffraction grating can be formed similarly.

<Modified Example of Mask>

The mask can be modified in the same manner as the first embodiment, where regarding not only the equally-spaced mask 40 shown in FIG. 16A but also the unequally-spaced mask 40a shown in FIG. 18A, the angle (depth) -changeable masks 40b and 40c, shown in FIGS. 19A and 19B, where the auxiliary patterns have been arranged in addition to the main patterns, and the angle (depth) -changeable mask 40d, shown in FIG. 20A, where the lines and spaces has been arranged to have a resolution equal to or less than a resolution limit, a diffraction grating can be similarly formed.

<Advantageous Effect of Second Embodiment>

According to the second embodiment described above, advantageous effects similar to those of the first embodiment can be obtained by using the aperture 20 (20a to 20d) provided with an opening portion asymmetric with respect to an optical axis and the aperture 80 provided with an inverted opening portion asymmetric with respect to the aperture 20 and using the mask 40 (40a to 40d) where patterns are arranged corresponding to blazed pitches in the diffraction grating, causing light emitted from the illumination light source to pass through the mask 40 (40a to 40d) via the aperture 20 (20a to 20d) and the aperture 80, causing zero-order light and first-order light generated by causing the light to pass through the mask 40 (40a to 40d) to interfere with each other on the surface of the Si wafer to expose the photoresist on the + defocus side and/or the - defocus side of the DOF, and manufacturing a diffraction grating where the photoresist having the equally-spaced or unequally-space blazed sectional shape with equal angles (depths) or different angles (depths) has been formed on the Si wafer.

[Third Embodiment]

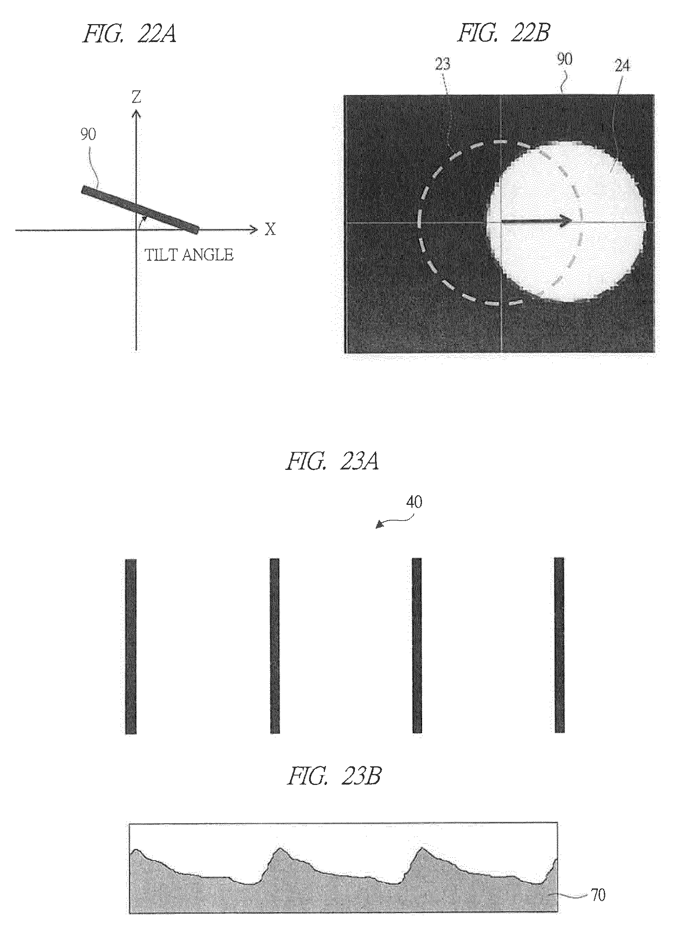

A third embodiment of the present invention will be described with reference to FIGS. 22A and 22B and FIGS. 23A and 23B.

In a method of manufacturing a diffraction grating according to the third embodiment, when an illumination shape asymmetric with respect to an optical axis is formed, an aperture provided with an opening portion being symmetric with respect to an optical axis is used in an inclined fashion with respect to the optical axis. Further, as the mask, a mask in which patterns are arranged corresponding to blazed pitches (equally spaced, or unequally spaced) of a diffraction grating is used. When a photoresist on a surface of a Si wafer is exposed, light emitted from a light source is caused to pass through the mask via the aperture, zero-order light and first-order light generated by causing the light to pass through the mask are caused to interfere with each other on a surface of the Si wafer, and a photoresist is exposed on a defocus side (+ defocus side, - defocus side) of a focal range where a constant imaging performance can be maintained, a diffraction grating having a blazed sectional shape is formed on the Si wafer. In the following, portions of the third embodiment different from the first and second embodiments will be mainly described specifically with reference to FIGS. 22A and 22B and FIGS. 23A and 23B.

<Exposure Apparatus (Tilted Illumination Method)>

An exposure apparatus realizing a method of manufacturing a diffraction grating according to the third embodiment will be described with reference to FIGS. 22A and 22B and FIGS. 23A and 23B. FIGS. 22A and 22B are schematic diagrams showing one example of an exposure apparatus and an aperture used therein, FIG. 22A shows summary of a tilted illumination method used in the exposure apparatus, and FIG. 22B shows a shape of an aperture. FIGS. 23A and 23B are schematic diagrams showing one example of a mask used in the exposure apparatus shown in FIG. 22A and a resist shape, FIG. 23A shows a summary of the mask, and FIG. 23B shows a sectional shape of a photoresist corresponding to the mask shown in FIG. 23A according to simulation.

The third embodiment is configured to obtain an effect similar to a deformed illumination in a pseudo manner by tilting an aperture 90 as shown in FIG. 22A without making the illumination shape asymmetric like the first and second embodiments. That is, as the aperture 90, one provided with an opening portion 23 symmetrical with respect to an optical axis, as shown by a broken line in FIG. 22B is used. When a photoresist on a surface of a Si wafer is exposed, the aperture 90 is tilted to X axis passing through the optical axis by a tilt angle (for example, 20°). Thereby, an illumination shape provided with an opening portion 24 (white representation) asymmetric with respect to the optical axis in a pseudo manner can be formed, as shown in FIG. 22B.

Further, by using an equally-spaced mask 40 (the same as that in FIG. 16A), such as shown in FIG. 23A, as the mask used in the third embodiment, a diffraction grating with a photoresist 70 having a blazed sectional shape, such as shown in FIG. 23B, can be formed.

<Modified Example of Aperture>

The aperture can be modified in the same manner as the first embodiment such that, when an aperture with an opening portion symmetrical with respect to the optical axis obtained by changing each of the apertures 20a to 20d shown in FIGS. 17B to 17E is used as an aperture other than the aperture 90 shown in FIGS. 22A and 22B, a diffraction grating can be formed by performing exposure in an tilted state similarly. For example, an aperture with a circular opening portion can be obtained by modifying the opening portion shown in FIG. 17B, an aperture with four circular opening portions can be obtained by modifying the opening portions shown in FIG. 17C, an aperture with a ring-shaped opening portion can be obtained by modifying the opening portion shown in FIG. 17D, and an aperture with two 1/6 ring-shaped opening portion can be obtained by modifying the opening portion shown in FIG. 17E.

<Modified Example of Mask>

The mask can be modified in the same manner as the first embodiment, where regarding not only the equally-spaced mask 40 shown in FIG. 23A but also the unequally-spaced mask 40a shown in FIG. 18A, the angle (depth) -changeable masks 40b and 40c, shown in FIGS. 19A and 19B, where the auxiliary patterns have been arranged in addition to the main patterns, and the angle (depth) -changeable mask 40d, shown in FIG. 20A, where the lines and spaces has been arranged to have a resolution less than or equal to a resolution limit, a diffraction grating can be similarly formed.

<Advantageous Effect of Third Embodiment>

According to the third embodiment described above, advantageous effects similar to those of the first embodiment can be obtained by using the aperture 90 provided with an opening portion symmetrical with respect to an optical axis in a titling fashion to the optical axis and using the mask 40 (40a to 40d) where patterns are arranged corresponding to blazed pitches in the diffraction grating, causing light emitted from the illumination light source to pass through the mask 40 (40a to 40d) via the aperture 90, causing zero-order light and first-order light generated by causing the light to pass through the mask 40 (40a to 40d) to interfere with each other on the surface of the Si wafer to expose the photoresist on the + defocus side or the - defocus side of the DOF, and manufacturing a diffraction grating where the photoresist having the equally-spaced or unequally-spaced blazed sectional shape with equally-angled (depth) or unequally-angled (depth) has been formed on the Si wafer.

Although the invention which has been made by the present inventors has been specifically described above based upon the embodiments, it is not limited to the embodiments, and it can be modified variously without deviating from the gist of the present invention.

For example, in each embodiment, when an illumination shape asymmetric with respect to an optical axis is formed, the illumination shape asymmetric with respect to an optical axis is achieved by using an aperture, but the present invention is not limited to such a method, and such an apparatus that an illumination light source itself emits light having an illumination shape asymmetric with respect to an optical axis can be used.

Further, even when an aperture is used, the aperture to be used is not limited to each of the apertures provided with the opening portions having the shapes shown in FIGS. 17A to 17E, and the shape of the opening portion may be modified variously. Further, when blazed angle (depth) is changed regarding the mask, a mask having auxiliary patterns different from auxiliary patterns such as shown in FIGS. 19A or 19B or a mask having lines and spaces different from lines and spaces such as those shown in FIG. 20A can be used.

Though the method of manufacturing a diffraction grating according to the present invention has been described above, the present invention is not limited to the method of manufacturing a diffraction grating, and it can be applied to a semiconductor device manufacturing method including an asymmetric shape. For example, when an asymmetric shape is required as a sectional shape, an asymmetric sectional shape can be formed on a semiconductor substrate by applying one of the first to third embodiments to a portion of MEMS (Micro Electro Mechanical Systems). Further, the asymmetric sectional shape is not limited to the photosensitive material and a sectional shape of a photosensitive material is transferred to a semiconductor substrate by applying a known semiconductor etching process, so that an asymmetric sectional shape can be formed on the semiconductor substrate.

[Industrial Applicability of the Second Technique]

The method of manufacturing a diffraction grating of the present invention can be particularly applied to a method for manufacturing a diffraction grating having a blazed sectional shape by applying a three-dimensional resist pattern forming technique using a deformed illumination method.

[Explanation of Reference Numerals of the First technique (FIG. 1 to FIG. 13B)]

| | |
|---|---|
| 10, 10' | gray-scale mask |
| 20 | binary mask |
| 100 | diffraction grating |
| 200 | spectrophotometer |
| 201 | light source |
| 202 | monochromater |
| 203 | sample side beam |
| 204 | reference side beam |
| 205 | sample |
| 206 | light detector |
| 207 | CPU |
| 208 | display/recording section |
| 209 | wavelength driving system |

[Explanation of Reference Numerals of the Second Technique (FIG. 14A to FIG. 23B)]

| | |
|---|---|
| 10 | illumination light source |
| 20, 20a, 20b, 20c, 20d | aperture |
| 21, 21a, 21b, 21c, 21d | opening portion |
| 22 | shielding portion |
| 23 | opening portion |
| 24 | opening portion |
| 30 | condensing lens |
| 40, 40a, 40b, 40c, 40d | mask |
| 41, 41a, 41b | line |
| 42 | space |
| 43a, 43b | line |
| 44 | lines and spaces |
| 50 | projection lens |
| 60 | Si wafer |
| 70 | photoresist |
| 80 | aperture |
| 90 | aperture |

**Claims**

1. A method of manufacturing a diffraction grating, comprising: setting an exposure condition such that, with respect to an opening portion shape of a mask having an opening portion with a periodic structure, a sectional shape of a convex portion of a resist on a substrate, the convex having been formed by exposure, is an asymmetric triangle and an angle formed by a long side and a short side of the triangle is about 90°; and performing exposure.

2. The method of manufacturing a diffraction grating according to claim 1, wherein at least one of the opening portion shape of the mask, an exposure focus, an exposure amount, a numerical aperture of an exposure lens, and a σ value of illumination is changed and comparison of sectional shapes of the convex portions of the resists on the substrate formed by exposure is performed.

3. The method of manufacturing a diffraction grating according to claim 1, wherein the mask has a periodic structure in a perpendicular direction or a parallel direction to with respect to a direction of grooves of the diffraction grating.

4. The method of manufacturing a diffraction grating according to claim 1, wherein the mask is such a mask that is provided with openings formed at a finer resolution than a resolution upon exposure and that the exposure amount continuously changes on the substrate in a pseudo manner according to location.

5. The method of manufacturing a diffraction grating according to claim 1, wherein a transmittance distribution according to location on the mask is substantially similar to one obtained by adding a correction term to a sectional shape of grooves of a diffraction grating to be manufactured.

6. The method of manufacturing a diffraction grating according to claim 1, wherein an antireflection film is provided on the substrate.

7. The method of manufacturing a diffraction grating according to claim 1, wherein a dielectric film is formed at an upper layer of the resist formed on the substrate.

8. The method of manufacturing a diffraction grating according to claim 1, wherein a metal film is formed at an upper layer of the resist formed on the substrate.

9. A method of manufacturing a diffraction grating, comprising: performing exposure to an opening portion shape of a mask having an opening portion with a periodic structure in accordance with each shift of the mask by a predetermined distance in a predetermined direction with respect to a substrate; setting an exposure condition such that a sectional shape of a convex portion of a resist on the substrate, the convex portion having been formed by the exposure, is an asymmetric triangle and an angle formed by a long side and a short side of the triangle is about 90°; and performing exposure.

10. The method of manufacturing a diffraction grating according to claim 9, wherein the mask has openings in a direction parallel to a direction of grooves of the diffraction grating, and the mask is shifted in a direction perpendicular to the direction of the grooves of the diffraction grating.

11. The method of manufacturing a diffraction grating according to claim 9, wherein at least one of a shift distance of the mask, a focus of the exposure, an exposure amount, a numerical aperture of an exposure lens, and σ value of illumination is changed and comparison of the sectional shapes of the convex portions of the resists on the substrate formed by the exposures is performed.

12. A spectrophotometer mounted with a diffraction grating, wherein
the diffraction grating is a diffraction grating which is manufactured by performing exposure to an opening portion shape of a mask having an opening portion with a periodic structure while shifting the mask in a predetermined direction with respect to a substrate, setting an exposure condition such that a sectional shape of a convex portion of a resist on the substrate, the convex portion having been formed by the exposure, is an asymmetric triangle and an angle formed by a long side and a short side of the triangle is about 90°, and performing exposure.

13. A method of manufacturing a diffraction grating having a blazed sectional shape, comprising:

shaping light emitted from a light source to an illumination shape being asymmetric with respect to an optical axis and causing the light to pass through a mask provided with predetermined periodic patterns;
causing zero-order light and first-order light generated by causing the light to pass through the mask to interfere with each other on a surface of the substrate and expose a photosensitive material on the surface of the substrate; and
forming a diffraction grating having the blazed sectional shape on the substrate.

14. The method of manufacturing a diffraction grating according to claim 13, further comprising:

using an aperture provided with an opening portion being asymmetric with respect to the optical axis when shaping the illumination shape being asymmetric with respect to the optical axis;
using, as the mask, a mask in which patterns are arranged corresponding to blazed pitches of the diffraction grating;
when exposing a photosensitive material on a surface of the substrate,
causing light emitted from the light source to pass through the mask via the aperture;
causing zero-order light and first-order light generated by causing the light to pass through the mask to interfere with each other on a surface of the substrate to expose the photosensitive material on a defocus side of a focal range where a constant imaging performance can be maintained; and
forming a diffraction grating having the blazed sectional shape on the substrate.

15. The method of manufacturing a diffraction grating according to claim 14, further comprising:

using, as the mask, a mask in which main patterns are arranged corresponding to blazed pitches of the diffraction grating and auxiliary patterns are disposed between the main patterns;
when exposing a photosensitive material on a surface of the substrate,
causing light emitted from the light source to pass through the mask via the aperture;
causing zero-order light and first-order light generated by causing the light to pass through the mask to interfere with each other on a surface of the substrate to expose the photosensitive material on a defocus side of a focal range where a constant imaging performance can be maintained; and
adjusting the sizes of the auxiliary patterns to change the angle of the blazed shape of the diffraction grating.

16. The method of manufacturing a diffraction grating according to claim 14, further comprising:

using, as the mask, a mask in which line-and-space patterns arranged so as to be equal to or less than a resolution limit are arranged corresponding to blazed-shaped pitches of the diffraction grating;
when exposing a photosensitive material on the surface of the substrate;

causing light emitted from the light source to pass through the mask via the aperture;
causing zero-order light and first-order light generated by causing the light to pass through the mask to interfere with each other on a surface of the substrate to expose the photosensitive material on a defocus side of a focal range where a constant imaging performance can be maintained; and
changing the lengths of the line-and-space patterns to change the angle of the blazed shape of the diffraction grating.

17. The method of manufacturing a diffraction grating according to claim 14, wherein
the blazed-shaped pitches of the diffraction grating are equally spaced or unequally spaced in one diffraction grating.

18. The method of manufacturing a diffraction grating according to claim 14, wherein
blazed angles of the diffraction grating are equal to one another or different from one another in one diffraction grating.

19. The method of manufacturing a diffraction grating according to claim 13, further comprising:

when forming an illumination shape asymmetric with respect to the optical axis, using a first aperture provided with an opening portion being asymmetric with respect to the optical axis and a second aperture provided with an opening portion asymmetric with respect to the first aperture and reverted to the first aperture;
using, as the mask, a mask in which patterns are arranged corresponding to blazed pitches of the diffraction grating;
when exposing a photosensitive material on a surface of the substrate,
causing light emitted from the light source to pass through the mask via the first aperture and the second aperture;
causing zero-order light and first-order light generated by causing the light to pass through the mask to interfere with each other on a surface of the substrate to expose the photosensitive material on a defocus side of a focal range where a constant imaging performance can be maintained; and
forming a diffraction grating having the blazed sectional shape on the substrate.

20. The method of manufacturing a diffraction grating according to claim 19, further comprising:

using, as the mask, a mask in which main patterns are arranged corresponding to blazed pitches of the diffraction grating and auxiliary patterns are arranged among the main patterns;
when exposing a photosensitive material on a surface of the substrate,
causing light emitted from the light source to pass through the mask via the first aperture and the second aperture;
causing zero-order light and first-order light generated by causing the light to pass through the mask to interfere with each other on a surface of the substrate to expose the photosensitive material on a defocus side of a focal range where a constant imaging performance can be maintained; and
adjusting the sizes of the auxiliary patterns to change blazed angles of the diffraction grating.

21. The method of manufacturing a diffraction grating according to claim 19, further comprising:

using, as the mask, a mask in which line-and-space patterns arranged so as to be equal to or less than a resolution limit are arranged corresponding to blazed pitches of the diffraction grating;
when exposing a photosensitive material on the surface of the substrate,
causing light emitted from the light source to pass through the mask via the first aperture and the second aperture;
causing zero-order light and first-order light generated by causing the light to pass through the mask to interfere with each other on a surface of the substrate to expose the photosensitive material on a defocus side of a focal range where a constant imaging performance can be maintained; and
changing the lengths of the line-and-space patterns to change the blazed angles of the diffraction grating.

22. The method of manufacturing a diffraction grating according to claim 19, wherein
the blazed pitches of the diffraction grating are equally spaced or unequally spaced in one diffraction grating.

23. The method of manufacturing a diffraction grating according to claim 19, wherein
blazed angles of the diffraction grating are equal to one another or different from one another in one diffraction grating.

24. The method of manufacturing a diffraction grating according to claim 13, further comprising:

when forming an illumination shape asymmetric with respect to the optical axis, using an aperture provided with an opening portion symmetrical with respect to the optical axis in an tilted fashion to the optical axis;

using, as the mask, a mask in which patterns are arranged corresponding to blazed pitches of the diffraction grating;

when exposing a photosensitive material on a surface of the substrate,

causing light emitted from the light source to pass through the mask via the aperture;

causing zero-order light and first-order light generated by causing the light to pass through the mask to interfere with each other on a surface of the substrate to expose the photosensitive material on a defocus side of a focal range where a constant imaging performance can be maintained; and

forming a diffraction grating having a blazed sectional shape on the substrate.

25. The method of manufacturing a diffraction grating according to claim 24, further comprising:

using, as the mask, a mask in which main patterns are arranged corresponding to blazed pitches of the diffraction grating and auxiliary patterns are arranged between the main patterns;

when exposing a photosensitive material on a surface of the substrate,

causing light emitted from the light source to pass through the mask via the aperture;

causing zero-order light and first-order light generated by causing the light to pass through the mask to interfere with each other on a surface of the substrate to expose the photosensitive material on a defocus side of a focal range where a constant imaging performance can be maintained; and

adjusting the sizes of the auxiliary patterns to change blazed angles of the diffraction grating.

26. The method of manufacturing a diffraction grating according to claim 24, further comprising:

using, as the mask, a mask in which line-and-space patterns arranged so as to be equal to or less than a resolution limit are arranged corresponding to blazed pitches of the diffraction grating;

when exposing a photosensitive material on the surface of the substrate,

causing light emitted from the light source to pass through the mask via the aperture;

causing zero-order light and first-order light generated by causing the light to pass through the mask to interfere with each other on a surface of the substrate to expose the photosensitive material on a defocus side of a focal range where a constant imaging performance can be maintained; and

changing the lengths of the line-and-space patterns to change the blazed angles of the diffraction grating.

27. The method of manufacturing a diffraction grating according to claim 24, wherein
the blazed pitches of the diffraction grating are equally spaced or unequally spaced in one diffraction grating.

28. The method of manufacturing a diffraction grating according to claim 24, wherein
blazed angles of the diffraction grating are equal to one another or different from one another in one diffraction grating.

29. A semiconductor device manufacturing method having an asymmetric sectional shape, comprising:

shaping light emitted from a light source in an illumination shape asymmetric with respect to an optical axis to cause the light to pass through a mask provided with predetermined periodic patterns;

causing zero-order light and first-order light generated by causing the light to pass through the mask to interfere with each other on a surface of a semiconductor substrate and expose a photosensitive material on a surface of the semiconductor substrate; and

forming the asymmetric sectional shape on the semiconductor substrate.

30. The semiconductor device manufacturing method according to claim 29, further comprising:

transferring the sectional shape of the photosensitive material on the semiconductor substrate to form an asymmetric sectional shape on the semiconductor substrate.

FIG. 1

10

(REFERENCE)
CORRESPONDING
SECTIONAL SHAPE

FIG. 2

100

10. 05°

0. 275 μm

1. 6 μm

## FIG. 3

| (1) MANUFACTURE GRAY-SCALE MASK 10 HAVING TRANSMITTANCE DISTRIBUTION APPROXIMATELY PROPORTIONAL TO DEPTH DISTRIBUTION OF GROOVES OF SECTION OF DIFFRACTION GRATING TO BE MANUFACTURED |

↓

| (2) AFTER APPLYING PHOTORESIST TO Si WAFER FOR TEST EXPOSURE BY SPIN COATER, PERFORM PRE-BAKING |

↓

| (3) TRANSFER TRANSMITTANCE DISTRIBUTION ON GRAY-SCALE MASK 10 ON Si WAFER OF (2) USING GRAY-SCALE MASK 10 IN REDUCED PROJECTION EXPOSURE APPARATUS. AT THIS TIME, WHILE CHANGING REGION ON THE Si WAFER, CHANGE EACH OF FOCUS VALUE, EXPOSURE AMOUNT, NUMERICAL APERTURE OF EXPOSURE LENS, AND $\sigma$ VALUE Of ILLUMINATION OF THE EXPOSURE APPARATUS IN A PLURALITY OF STEPS TO REPEAT THE TRANSFER BY A PLURALITY OF SHOTS |

↓

| (4) AFTER DEVELOPING Si WAFER OF (3), PERFORM POST-BAKING |

↓

| (5) MEASURE SECTIONAL SHAPE OF THREE-DIMENSIONAL PHOTORESIST PATTERN FORMED ON Si WAFER OF (4), SELECT A SHOT WHERE THE SECTIONAL SHAPE OPTIMALLY COINCIDENT WITH SECTIONAL SHAPE OF DIFFRACTION GRATING TO BE MANUFACTURED (FOR EXAMPLE, FIG. 3 IN THIS EXAMPLE), AND RECORD THE FOCUS VALUE AND THE EXPOSURE AMOUNT AS OPTIMAL EXPOSURE CONDITIONS |

↓

| (6) IF GOOD MATCH WITH SECTIONAL SHAPE OF DIFFRACTION GRATING TO BE MANUFACTURED CANNOT BE FOUND IN ANY SHOT, CHANGE TRANSMITTANCE DISTRIBUTION OF GRAY-SCALE MASK 10 MANUFACTURED AT (1) AND MANUFACTURE NEW GRAY-SCALE MASK TO REPEAT PROCEDURE FROM (2) TO (5) AGAIN. WHEN A SHOT WHICH SUCCESSFULLY MATCHES WITH SECTIONAL SHAPE OF DIFFRACTION GRATING TO BE MANUFACTURED EXISTS, PROCEED TO PROCEDURE OF (7) |

↓

| (7) AFTER APPLING PHOTORESIST TO Si WAFER FOR DIFFRACTION GRATING MANUFACTURE BY SPIN COATER, PERFORM PRE-BAKING |

↓

| (8) TRANSFER TRANSMITTANCE DISTRIBUTION ON THE GRAY-SCALE MASK 10 TO Si WAFER OF (7) USING GRAY-SCALE MASK 10 IN REDUCED PROJECTION EXPOSURE APPARATUS. AT THIS TIME, SET FOCUS VALUE AND EXPOSURE AMOUNT RECORDED AT (5) IN THE EXPOSURE APPARATUS |

↓

| (9) AFTER DEVELOPING Si WAFER OF (8), PERFORM POST-BAKING |

↓

| (10) FORM Al FILM ON Si WAFER OF (9) |

↓

| (11) DICE DIFFRACTION GRATING FORMED AT (10) TO PROPER SIZE |

## *FIG. 4*

(1) PRODUCE TRANSMITTANCE DISTRIBUTION DATA OF GRAY-SCALE MASK 10 HAVING TRANSMITTANCE DISTRIBUTION APPROXIMATELY PROPORTIONAL TO DEPTH DISTRIBUTION OF SECTION OF DIFFRACTION GRATING TO BE MANUFACTURED

↓

(2) INPUT TRANSMITTANCE DISTRIBUTION DATA OF (1), CHARACTERISTIC DATA OF REDUCED PROJECTION EXPOSURE APPARATUS, CHARACTERISTIC DATA OF PHOTORESIST, AND ACTUAL NUMERICAL VALUES OF OTHER PARAMETERS REQUIRED INTO EXPOSURE SIMULATOR TO SIMULATE SECTIONAL SHAPE OF THREE-DIMENSIONAL PHOTORESIST PATTERN WHICH MAY BE FORMED ON Si WAFER AS RESULT OF APPLICATION → PREBAKING → EXPOSURE → DEVELOPMENT → POST-BAKING. AT THIS TIME, WHILE CHANGING REGION ON Si WAFER, CHANGE EACH OF FOCUS VALUE, EXPOSURE AMOUNT, NUMERICAL APERTURE OF EXPOSURE LENS, AND $\sigma$ VALUE OF ILLUMINATION OF THE EXPOSURE APPARATUS IN A PLURALITY OF STEPS TO REPEAT THE TRANSFER BY A PLURALITY OF SHOTS, THEREBY PERFORMING SIMULATION

↓

(3) SELECT A SHOT WHERE THE SECTIONAL SHAPE OF SECTIONAL SHAPES OF THREE-DIMENSIONAL PHOTORESIST PATTERNS OF SIMULATION RESULT OF (2) OPTIMALLY COINCIDES WITH SECTIONAL SHAPE OF DIFFRACTION GRATING TO BE MANUFACTURED (FOR EXAMPLE, FIG. 3 IN THIS EXAMPLE) TO RECORD THE FOCUS VALUE AND THE EXPOSURE AMOUNT AS OPTIMAL EXPOSURE CONDITIONS

↓

(4) IF GOOD MATCH WITH SECTIONAL SHAPE OF DIFFRACTION GRATING TO BE MANUFACTURED CANNOT BE FOUND IN ANY SHOT, CHANGE TRANSMITTANCE DISTRIBUTION OF GRAY-SCALE MASK 10 MANUFACTURED AT (1) AND PRODUCE NEW TRANSMITTANCE DISTRIBUTION DATA TO REPEAT PROCEDURE FROM (2) TO (3) AGAIN. WHEN A SHOT WHICH SUCCESSFULLY MATCHES WITH SECTIONAL SHAPE OF DIFFRACTION GRATING TO BE MANUFACTURED EXISTS, PROCEED TO PROCEDURE OF (5)

↓

(5) MANUFACTURE GRAY-SCALE MASK 10 ACCORDING TO TRANSMITTANCE DISTRIBUTION DATA DETERMINED AT (3) AND (4)

↓

(6) AFTER APPLING PHOTORESIST TO Si WAFER FOR DIFFRACTION GRATING MANUFACTURE BY SPIN COATER, PERFORM PRE-BAKING

↓

(7) TRANSFER TRANSMITTANCE DISTRIBUTION ON THE GRAY-SCALE MASK 10 TO Si WAFER OF (6) USING GRAY-SCALE MASK 10 IN REDUCED PROJECTION EXPOSURE APPARATUS. AT THIS TIME, SET FOCUS VALUE AND EXPOSURE AMOUNT RECORDED AT (3) IN THE EXPOSURE APPARATUS

↓

(8) AFTER DEVELOPING Si WAFER OF (7), PERFORM POST-BAKING

↓

(9) FORM Al FILM ON Si WAFER OF (8)

↓

(10) DICE DIFFRACTION GRATING FORMED AT (9) TO PROPER SIZE

## FIG. 5

FOCUS

REMARK) HORIZONTAL AXIS OF EACH GRAPH REPRESENTS POSITION
COORDINATE IN ARRANGEMENT DIRECTION OF
GROOVES OF DIFFRACTION GRATING,
AND VERTICAL AXIS REPRESENTS COORDINATE OF GROOVE DEPTH DIRECTION.

## FIG. 6

NA OF EXPOSURE LENS/ $\sigma$ OF ILLUMINATION

REMARK) HORIZONTAL AXIS OF EACH GRAPH REPRESENTS POSITION
COORDINATE IN ARRANGEMENT DIRECTION OF
GROOVES OF DIFFRACTION GRATING,
AND VERTICAL AXIS REPRESENTS COORDINATE OF GROOVE DEPTH DIRECTION.

## FIG. 7

10'

(REFERENCE)
CORRESPONDING
SECTIONAL SHAPE

*FIG. 8*

20    W

(REFERENCE)
CORRESPONDING
SECTIONAL SHAPE

P

## FIG. 9

(1) MANUFACTURE BINARY MASK 20 WHERE STRAIGHT SLIT-SHAPED OPENINGS HAVING WIDTH EQUAL TO EACH WIDTH OF ABOUT N PIECES OBTAINED BY DIVISION OF GROOVE PERIOD OF DIFFRACTION GRATING TO BE MANUFACTURED ARE ARRANGED IN A PLURALITY OF ROWS IN PARALLEL CORRESPONDING TO THE GROOVE PERIOD

↓

(2) AFTER APPLYING PHOTORESIST TO Si WAFER FOR TEST EXPOSURE BY SPIN COATER, PERFORM PRE-BAKING

↓

(3) DISCRETELY SHIFT THE BINARY MASK 20 TO Si WAFER OF (2) IN ARRANGEMENT DIRECTION OF GROOVES OF DIFFRACTION GRATING IN REDUCED PROJECTION EXPOSURE APPARATUS TO PERFORM EXPOSURE FOR EACH SHIFT WHILE CHANGING EXPOSURE AMOUNT. AT THIS TIME, WHILE CHANGING REGION ON Si WAFER, CHANGE EACH OF FOCUS VALUE, EXPOSURE AMOUNT FOR EACH SHIFT, NUMERICAL APERTURE OF EXPOSURE LENS, AND $\sigma$ VALUE OF ILLUMINATION OF THE EXPOSURE APPARATUS IN A PLURALITY OF STAGES TO REPEAT THE TRANSFER BY A PLURALITY OF SHOTS

↓

(4) AFTER DEVELOPING Si WAFER OF (3), PERFORM POST-BAKING

↓

(5) MEASURE SECTIONAL SHAPE OF THREE-DIMENSIONAL PHOTORESIST PATTERN FORMED ON Si WAFER OF (4), SELECT A SHOT WHERE THE SECTIONAL SHAPE OPTIMALLY COINCIDENT WITH SECTIONAL SHAPE OF DIFFRACTION GRATING TO BE MANUFACTURED (FOR EXAMPLE, FIG. 13A IN THIS EXAMPLE), AND RECORD THE FOCUS VALUE AND THE EXPOSURE LEVEL FOR EACH SHIFT AS OPTIMAL EXPOSURE CONDITIONS

↓

(6) IF GOOD MATCH WITH SECTIONAL SHAPE OF DIFFRACTION GRATING TO BE MANUFACTURED CANNOT BE FOUND IN ANY SHOT, CHANGE OPENING WIDTH OF BINARY MASK 20 MANUFACTURED AT (1) AND MANUFACTURE NEW BINARY MASK TO REPEAT PROCEDURE FROM (2) TO (5) AGAIN. WHEN A SHOT WHICH SUCCESSFULLY MATCHES WITH SECTIONAL SHAPE OF DIFFRACTION GRATING TO BE MANUFACTURED EXISTS, PROCEED TO PROCEDURE OF (7)

↓

(7) AFTER APPLING PHOTORESIST TO Si WAFER FOR DIFFRACTION GRATING MANUFACTURE BY SPIN COATER, PERFORM PRE-BAKING

↓

(8) DISCRETELY SHIFT THE BINARY MASK 20 TO Si WAFER OF (7) IN ARRANGEMENT DIRECTION OF GROOVES OF DIFFRACTION GRATING IN REDUCED PROJECTION EXPOSURE APPARATUS AND PERFORM EXPOSURE WITH EXPOSURE AMOUNT DETERMINED FOR EACH SHIFT. AT THIS TIME, SET FOCUS VALUE AND EXPOSURE LEVEL FOR EACH SHIFT RECORDED AT (5) IN THE EXPOSURE APPARATUS

↓

(9) AFTER DEVELOPING Si WAFER OF (8), PERFORM POST-BAKING

↓

(10) FORM Al FILM ON Si WAFER OF (9)

↓

(11) DICE DIFFRACTION GRATING FORMED AT (10) TO PROPER SIZE

## FIG. 10

(1) DETERMINE OPENING WIDTH OF BINARY MASK 20 WHERE STRAIGHT SLIT-SHAPED OPENINGS HAVING WIDTH EQUAL TO EACH WIDTH OF ABOUT N PIECES OBTAINED BY DIVISION OF GROOVE PERIOD OF DIFFRACTION GRATING TO BE MANUFACTURED ARE ARRANGED IN A PLURALITY OF ROWS IN PARALLEL CORRESPONDING TO THE GROOVE PERIOD

(2) INPUT OPENING WIDTH OF (1), CHARACTERISTIC DATA OF REDUCED PROJECTION EXPOSURE APPARATUS, CHARACTERISTIC DATA OF PHOTORESIST, AND ACTUAL NUMERICAL VALUES OF OTHER PARAMETERS REQUIRED INTO EXPOSURE SIMULATOR AND SIMULATE SECTIONAL SHAPE OF THREE-DIMENSIONAL PHOTORESIST PATTERN WHICH MAY BE FORMED ON Si WAFER AS RESULT OF APPLICATION → PREBAKING → EXPOSURE → DEVELOPMENT → POST-BAKING. WHILE CHANGING REGION ON Si WAFER, CHANGE EACH OF FOCUS VALUE, EXPOSURE AMOUNT, NUMERICAL APERTURE OF EXPOSURE LENS, AND σ VALUE OF ILLUMINATION OF THE EXPOSURE APPARATUS IN A PLURALITY OF STAGES TO REPEAT THE TRANSFER BY A PLURALITY OF SHOTS TO PERFORM SIMULATION

(3) SELECT A SHOT WHERE THE SECTIONAL SHAPE OF SECTIONAL SHAPES OF THREE-DIMENSIONAL PHOTORESIST PATTERN OF SIMULATION RESULT OF (2) OPTIMALLY COINCIDES WITH SECTIONAL SHAPE OF DIFFRACTION GRATING TO BE MANUFACTURED (FOR EXAMPLE, FIG. 13A) TO RECORD THE FOCUS VALUE AND THE EXPOSURE LEVEL AS OPTIMAL EXPOSURE CONDITIONS

(4) IF GOOD MATCH WITH SECTIONAL SHAPE OF DIFFRACTION GRATING TO BE MANUFACTURED CANNOT BE FOUND IN ANY SHOT, CHANGE WIDTH OF STRAIGHT SLIT-SHAPED OPENING OF BINARY MASK 20 DETERMINED AT (1) AND REPEAT PROCEDURE FROM (2) TO (3) AGAIN. WHEN A SHOT WHICH SUCCESSFULLY MATCHES WITH SECTIONAL SHAPE OF DIFFRACTION GRATING TO BE MANUFACTURED EXISTS, PROCEED TO PROCEDURE OF (5)

(5) MANUFACTURE BINARY MASK 20 ACCORDING TO WIDTH OF STRAIGHT SLIT-SHAPED OPENING DETERMINED AT (3) AND (4)

(6) AFTER APPLING PHOTORESIST TO Si WAFER FOR DIFFRACTION GRATING MANUFACTURE BY SPIN COATER, PERFORM PRE-BAKING

(7) DISCRETELY SHIFT THE BINARY MASK 20 TO Si WAFER OF (6) IN ARRANGEMENT DIRECTION OF GROOVES OF DIFFRACTION GRATING IN REDUCED PROJECTION EXPOSURE APPARATUS AND PERFORM EXPOSURE WHILE CHANGING EXPOSURE AMOUNT FOR EACH SHIFT. AT THIS TIME, SET FOCUS VALUE AND EXPOSURE LEVEL FOR EACH SHIFT RECORDED AT (3) IN THE EXPOSURE APPARATUS

(8) AFTER DEVELOPING Si WAFER OF (7), PERFORM POST-BAKING

(9) FORM Al FILM ON Si WAFER OF (8)

(10) DICE DIFFRACTION GRATING FORMED AT (9) TO PROPER SIZE

FIG. 11

OVERLAP AMOUNT

0nm                    100nm                    200nm

REMARK) HORIZONTAL AXIS OF EACH GRAPH REPRESENTS POSITION
COORDINATE IN ARRANGEMENT DIRECTION OF
GROOVES OF DIFFRACTION GRATING,
AND VERTICAL AXIS REPRESENTS COORDINATE OF GROOVE DEPTH DIRECTION.

FIG. 12

FIG. 13A

FIG. 13B

EP 2 711 746 A1

*FIG. 14A*

*FIG. 14B*

*FIG. 14C*

10

20

20

20

30

40

40

50

FIRST-ORDER
LIGHT

ZERO-ORDER
LIGHT

70

60

*FIG. 14D*

ZERO-ORDER
LIGHT

FIRST-ORDER
LIGHT

JUST FOCUS

*FIG. 14E*

| | OPTICAL IMAGE | RESIST SHAPE |
|---|---|---|
| − DEFOCUS | | ~90° |
| | | SHAPE INVERTED |
| + DEFOCUS | | |

*FIG. 15*

*FIG. 16A*

*FIG. 16B*

*FIG. 16C*

*FIG. 17A*  *FIG. 17B*  *FIG. 17C*  *FIG. 17D*  *FIG. 17E*

| | 20  21 | 20a  21a | 20b  21b  21b | 20c  21c | 20d  21d |
|---|---|---|---|---|---|
| ILLUMINATION SHAPE | | | | | |
| RESIST SHAPE | | | | | |

*FIG. 18A*

40a

41

*FIG. 18B*

70

FIG. 19A

FIG. 19B

FIG. 19C

FIG. 19D

FIG. 19E

40d

*FIG. 20A*

PITCH OF DIFFRACTION
GRATING

X

44

X=100nm

*FIG. 20B*

70

X=150nm

*FIG. 20C*

70

X=200nm

*FIG. 20D*

70

*FIG. 21A*  DOF ON RIGHT SIDE OF ONLY DEFORMED ILLUMINATION METHOD

| ILLUMINATION SHAPE | $-1.5\,\mu\mathrm{m}$ | $-1.3\,\mu\mathrm{m}$ | $-1.1\,\mu\mathrm{m}$ | $-0.9\,\mu\mathrm{m}$ | $-0.7\,\mu\mathrm{m}$ | $-0.5\,\mu\mathrm{m}$ | $-0.3\,\mu\mathrm{m}$ | $-0.1\,\mu\mathrm{m}$ |
|---|---|---|---|---|---|---|---|---|
| | SHAPE ✕ | SHAPE △ | SHAPE ◯ | SHAPE ◯ | SHAPE ◯ | SHAPE △ | SHAPE ✕ | SHAPE ✕ |

20  21

*FIG. 21B*  DOF ON LEFT SIDE OF ONLY DEFORMED ILLUMINATION METHOD

| ILLUMINATION SHAPE | $-0.1\,\mu\mathrm{m}$ | $+0.1\,\mu\mathrm{m}$ | $+0.3\,\mu\mathrm{m}$ | $+0.5\,\mu\mathrm{m}$ | $+0.7\,\mu\mathrm{m}$ | $+0.9\,\mu\mathrm{m}$ | $+1.1\,\mu\mathrm{m}$ | $+1.3\,\mu\mathrm{m}$ |
|---|---|---|---|---|---|---|---|---|
| | SHAPE ✕ | SHAPE △ | SHAPE ◯ | SHAPE ◯ | SHAPE ◯ | SHAPE △ | SHAPE ✕ | SHAPE ✕ |

21  80

*FIG. 21C*  DOUBLE EXPOSURE (a) + (b) DOF

| (a) FIRST EXPOSURE (b) SECOND EXPOSURE | (a) $-1.5\,\mu\mathrm{m}$ (b) $-0.1\,\mu\mathrm{m}$ | (a) $-1.3\,\mu\mathrm{m}$ (b) $+0.1\,\mu\mathrm{m}$ | (a) $-1.1\,\mu\mathrm{m}$ (b) $+0.3\,\mu\mathrm{m}$ | (a) $-0.9\,\mu\mathrm{m}$ (b) $+0.5\,\mu\mathrm{m}$ | (a) $-0.7\,\mu\mathrm{m}$ (b) $+0.7\,\mu\mathrm{m}$ | (a) $-0.5\,\mu\mathrm{m}$ (b) $+0.9\,\mu\mathrm{m}$ | (a) $-0.3\,\mu\mathrm{m}$ (b) $+1.1\,\mu\mathrm{m}$ | (a) $-0.1\,\mu\mathrm{m}$ (b) $+1.3\,\mu\mathrm{m}$ |
|---|---|---|---|---|---|---|---|---|
| RESIST SHAPE | SHAPE ◯ | SHAPE ◯ | SHAPE ◯ | SHAPE ◯ | SHAPE ◯ | SHAPE ◯ | SHAPE ◯ | SHAPE ◯ |

*FIG. 22A*

*FIG. 22B*

*FIG. 23A*

*FIG. 23B*

## INTERNATIONAL SEARCH REPORT

| | International application No. |
|---|---|
| | PCT/JP2012/062622 |

A. CLASSIFICATION OF SUBJECT MATTER
*G02B5/18*(2006.01)i, *G01J3/18*(2006.01)i, *G03F1/00*(2012.01)i, *G03F7/20* (2006.01)i, *H01L21/027*(2006.01)i

According to International Patent Classification (IPC) or to both national classification and IPC

B. FIELDS SEARCHED

Minimum documentation searched (classification system followed by classification symbols)
G02B5/18, G01J3/18, G03F1/00, G03F7/20, H01L21/027

Documentation searched other than minimum documentation to the extent that such documents are included in the fields searched
Jitsuyo Shinan Koho        1922-1996   Jitsuyo Shinan Toroku Koho   1996-2012
Kokai Jitsuyo Shinan Koho   1971-2012   Toroku Jitsuyo Shinan Koho   1994-2012

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 6-186412 A  (Olympus Optical Co., Ltd.), 08 July 1994 (08.07.1994), claim 1 (Family: none) | 1-12 |
| Y | JP 10-73724 A  (Sanyo Electric Co., Ltd.), 17 March 1998 (17.03.1998), paragraph [0046]; fig. 8 (Family: none) | 1-12 |
| Y | JP 2004-86073 A  (Hitachi Maxell, Ltd.), 18 March 2004 (18.03.2004), paragraphs [0003], [0005]; fig. 1, 2 (Family: none) | 1-12 |

| ☒  Further documents are listed in the continuation of Box C. | ☐  See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 18 September, 2012 (18.09.12) | 25 September, 2012 (25.09.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**EP 2 711 746 A1**

**INTERNATIONAL SEARCH REPORT**

| International application No. |
| --- |
| PCT/JP2012/062622 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2005-121938 A  (Nippon Sheet Glass Co., Ltd.),<br>12 May 2005 (12.05.2005),<br>paragraph [0060]; fig. 1<br>(Family: none) | 1-12 |
| Y | JP 2007-147926 A  (Lasertec Corp.),<br>14 June 2007 (14.06.2007),<br>paragraph [0071]; fig. 9<br>(Family: none) | 1-12 |
| Y | JP 7-98404 A  (Matsushita Electric Industrial Co., Ltd.),<br>11 April 1995 (11.04.1995),<br>claim 1<br>(Family: none) | 6 |
| Y | JP 2005-157118 A  (Shimadzu Corp.),<br>16 June 2005 (16.06.2005),<br>fig. 1(g)<br>& US 2005/0130072 A1 | 7-8 |
| Y | JP 10-113780 A  (Nikon Corp.),<br>06 May 1998 (06.05.1998),<br>paragraphs [0065] to [0081]; fig. 6 to 9<br>(Family: none) | 9-12 |

Form PCT/ISA/210 (continuation of second sheet) (July 2009)

**INTERNATIONAL SEARCH REPORT**

| International application No. |
| --- |
| PCT/JP2012/062622 |

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
```
   The item common to claims 1 and 13 is "a method for producing a diffraction
grating having a blazed cross-section shape." However, it is clear that this
common item is not a special technical feature, and no other common item exists
that can be considered as a special technical feature according to the meaning
of the second sentence of PCT Rule 13.2. Therefore, between the differing
inventions, it is not possible to find a technical relationship according
to the meaning of PCT Rule 13.
   Therefore, the two inventions indicated below are included in the claims:
(Invention 1) The invention as laid out in claims 1 to 12
(Invention 2) The invention as laid out in claims 13 to 30
```

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:

```
Claims 1 to 12
```

**Remark on Protest**      ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005011478 A
- JP 2006259325 A
- JP H11305023 B
- JP 2007155927 A
- JP 2002189112 A

**Non-patent literature cited in the description**

- **KEIEI KUDO.** BASE AND METHOD of SPECTRUM. Ohmsha Ltd